# EUROPEAN PATENT APPLICATION

(11) **EP 4 850 932 A1**
(43) Date of publication of application: **09.12.2026**
(21) Application number: 24922051.8
(22) Date of filing: 18.12.2024
(51) Int. Cl.: B60C 19/00, B60C 7/00, G06F 30/10, G06F 30/15, G06F 30/23

(54) **NON-PNEUMATIC-TIRE DESIGN DEVICE, METHOD, AND PROGRAM**

(30) Priority: 29.01.2024 JP 2024011147
(71) Applicant: BRIDGESTONE CORPORATION, Chuo-ku Tokyo 104-8340 (JP)
(72) Inventor: ABE, Akihiko, Tokyo 104-8340 (JP)
(74) Representative: Marks & Clerk LLP
(86) International application number: PCT/JP2024/044856
(87) International publication number: WO 2025/164133

(57) **Abstract**

A non-pneumatic tire designing device includes a setting unit that sets a tire basic model obtained by modeling a non-pneumatic tire including an inner cylindrical body, an outer cylindrical body, and a connection member that connects the inner cylindrical body and the outer cylindrical body with a finite number of elements, an objective function representing tire performance, a constraint condition that constrains an allowable range of the tire performance, and a design parameter used to determine positions of plural control points disposed along a shape of the connection member in the tire basic model, and a design parameter determination unit that sequentially changes a design variable included in the design parameter and determines the design parameter on the basis of a value of the design variable that gives an optimum value of the objective function while satisfying the constraint condition.

## Description

### Technical Field

The present disclosure relates to a non-pneumatic tire designing device, a method, and a program.

### Background Art

A device that simulates tire performance by rolling a tire basic model in which a tire is modeled by a finite number of elements on a virtual road surface by using a numerical analysis method such as a finite element method has been proposed. There is a technique of applying an airless tire model that models an airless tire as the tire (see, for example, Japanese Patent Application Laid-Open (JP-A) No. 2022-187341).

In an airless tire as another example of a tire, there is a technique of designing a tire in consideration of performance such as traction for an airless tire including first and second ends inside and outside and connected via blades (see, for example, Japanese National-Phase Publication (JP-A) No. 2016-505448).

### SUMMARY OF INVENTION

### Technical Problem

Tire performance may be evaluated by actually designing and manufacturing a tire, mounting the tire on an automobile, and performing a performance test. Therefore, in a case in which the result of the performance test is not satisfactory, a procedure of starting again from design and manufacturing is repeatedly performed. However, in designing a non-pneumatic tire such as an airless tire, in a case in which a non-pneumatic tire is modeled to simulate tire performance, considering design parameters related to tire performance involves enormous work. Thus, in the simulation of the tire performance, since trial and error are repeatedly performed with respect to the settings of the design parameters and the like, a processing load of the device increases, whereby enormous processing time or the like is required. Therefore, there is room for improvement in designing a non-pneumatic tire while simulating the performance of a non-pneumatic tire such as an airless tire.

In view of the above facts, the disclosure makes it possible to provide a non-pneumatic tire designing device, a method, and a program capable of reducing a processing load in a case in which a non-pneumatic tire such as an airless tire is designed.

### Solution to Problem

An aspect of the technology of the disclosure is a non-pneumatic tire designing device including:
a setting unit that sets a tire basic model obtained by modeling a non-pneumatic tire including an inner cylindrical body, an outer cylindrical body, and a connection member that connects the inner cylindrical body and the outer cylindrical body with a finite number of elements, an objective function representing tire performance of the non-pneumatic tire, a constraint condition that constrains an allowable range of the tire performance, and a design parameter used to determine positions of a plurality of control points disposed along a shape of the connection member in the tire basic model of the non-pneumatic tire; and
a design parameter determination unit that sequentially changes a design variable included in the design parameter and determines the design parameter on the basis of a value of the design variable that gives an optimum value of the objective function while satisfying the constraint condition.

### BRIEF DESCRIPTION OF DRAWINGS

Fig. 1 is a block diagram showing a schematic configuration of a tire designing device according to a first embodiment.
Fig. 2 is a diagram showing an electrical configuration of the tire designing device according to the first embodiment.
Fig. 3 is a diagram showing a functional configuration of the tire designing device according to the first embodiment.
Fig. 4 is a diagram showing an operation of the tire designing device according to the first embodiment.
Fig. 5 is a diagram showing processing of setting an initial structure of a non-pneumatic tire according to the first embodiment.
Fig. 6 is a diagram showing a plurality of control points according to the first embodiment.
Fig. 7 is a diagram showing a spoke including a plurality of control points according to the first embodiment.
Fig. 8 is a diagram showing a tire structure of the non-pneumatic tire according to the first embodiment.
Fig. 9 is a diagram showing an example of a plurality of control points according to the first embodiment.
Fig. 10 is a diagram showing a state in which a control point according to the first embodiment is moved.
Fig. 11 is a diagram showing design parameter setting processing according to the first embodiment.
Fig. 12 is a diagram showing processing of setting an initial structure of a non-pneumatic tire according to a second embodiment.
Fig. 13 is a diagram showing a plurality of control points according to the second embodiment.
Fig. 14 is a diagram showing a plurality of control points according to a third embodiment.
Fig. 15 is a diagram showing a functional configuration of a tire designing device according to a fourth embodiment.
Fig. 16 is a diagram showing an operation of a tire designing device in a fourth embodiment.
Fig. 17 is a diagram showing a functional configuration of a tire designing device in a fifth embodiment.
Fig. 18 is a diagram showing a configuration of a nonlinear calculation unit according to a fifth embodiment.
Fig. 19 is a diagram showing neural network learning processing according to the fifth embodiment.
Fig. 20 is a diagram showing an operation of the tire designing device in the fifth embodiment.
Fig. 21 is a diagram showing details of optimization processing according to the fifth embodiment.
Fig. 22 is a diagram showing an experimental result of an optimized non-pneumatic tire.

### DESCRIPTION OF EMBODIMENTS

Hereinafter, embodiments for realizing the technology of the disclosure will be described in detail with reference to the drawings.

Constituent elements and processes having the same operations and functions are denoted by the same reference numerals throughout the drawings, and redundant description may be omitted as appropriate. The disclosure is not limited to the following embodiments at all, and can be implemented with appropriate modifications within the scope of the object of the disclosure.

### <First Embodiment>

A non-pneumatic tire designing device according to the present embodiment calculates design parameters by using mathematical programming.

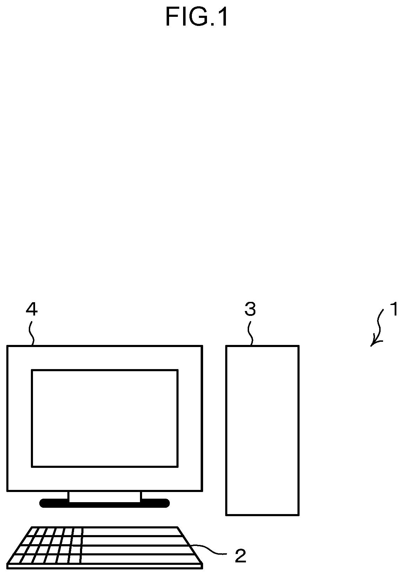

Fig. 1 is a diagram showing a schematic configuration of a tire designing device 1 that is a non-pneumatic tire designing device according to the present embodiment.

As shown in Fig. 1, the tire designing device 1 includes an input unit 2, a main body unit 3, and a display unit 4. The input unit 2 acquires design parameters and the like including design variables (hereinafter, referred to as design parameters), and examples thereof include input devices such as a keyboard and a mouse. The main body unit 3 configures a design parameter determination unit that determines a final design parameter on the basis of a design variable that gives an optimum value to an objective function while satisfying a constraint condition according to a preset program. The display unit 4 outputs a calculation result by the main body unit 3, and examples thereof include display devices such as a projection display and a liquid crystal display.

Here, the objective function is a function for expressing tire performance indicating physical properties and abilities of a non-pneumatic tire. Examples of tire performance of a non-pneumatic tire include belt tension, a lateral spring constant, rolling resistance, cornering power, and the like for improving steering stability.

In the present embodiment, the objective function is rolling resistance or an energy loss (hysteresis loss) generated in a case in which the non-pneumatic tire is distorted.

The constraint condition is a condition that constrains an allowable range of tire performance of the non-pneumatic tire. In the present embodiment, the constraint condition is a condition that constrains an allowable range of the cornering power.

The design parameters are parameters used to determine a structure of a tire basic model obtained by modeling a non-pneumatic tire including a finite number of elements, and include parameters used to determine positions of a plurality of control points disposed along a spoke as a connection member in the tire basic model. Specifically, the design parameters include parameters for determining positions of a plurality of control points disposed along a shape of a spoke in the tire basic model of a non-pneumatic tire obtained by modeling the non-pneumatic tire including an inner cylindrical body, an outer cylindrical body, and the spoke connecting the inner cylindrical body and the outer cylindrical body. In this case, in a case in which the tire basic model is two-dimensionally handled, parameters used to determine positions of the plurality of control points disposed along a tire cross-sectional shape of the tire basic model can be applied as the design parameters. The parameters for determining the positions of the respective control points may include a shape of the spoke (for example, a two-dimensional thickness such as a plate thickness) and a shape of the outer cylindrical body (for example, a two-dimensional thickness such as a plate thickness) at the position of each control point. In a case in which the shape of the spoke and the shape of the outer cylindrical body are included in the design parameters, parameters used to determine the plate thickness of the spoke and the plate thickness of the outer cylindrical body at the position of each control point in the tire cross-sectional shape can be applied. The objective function is a function of a design parameter. Therefore, the objective function is also changed by changing the design parameter. The position of the control point is not limited to the position itself, and may be a physical quantity that enables the position to be determined. The shape of the spoke may be a shape with the corresponding control point as a reference, and the shape of the outer cylindrical body may be a shape with a point at which the spoke and the outer cylindrical body are connected as a reference.

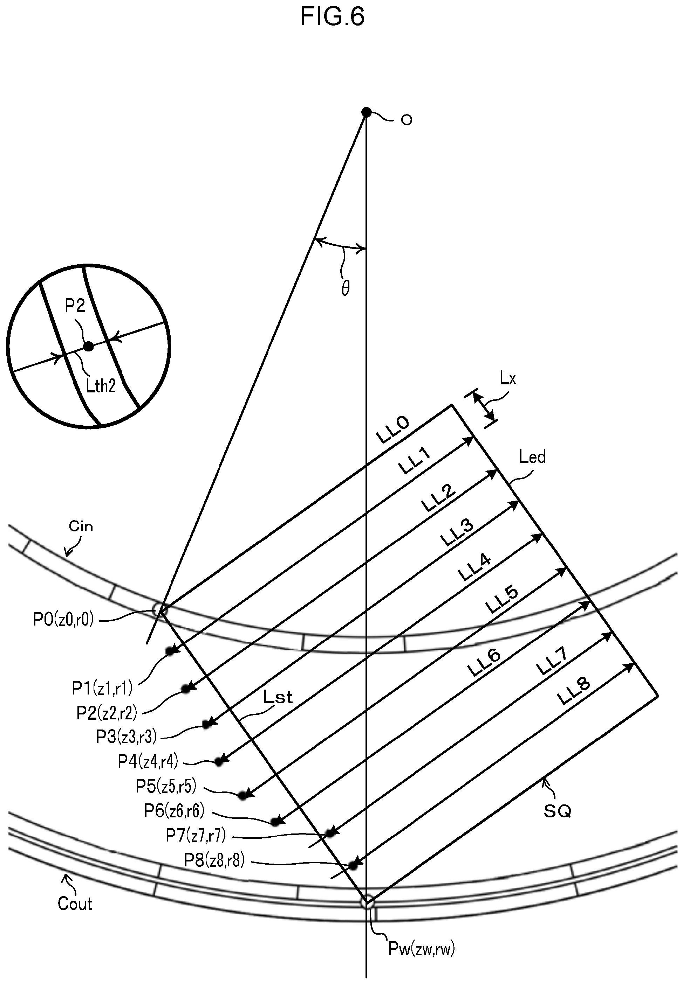

For example, in a case in which a plurality of control points (see a control point P shown in Fig. 6 that will be described later) capable of deforming the spoke in the tire cross-sectional shape are disposed along the shape of the spoke, a coordinate value of each control point, a value corresponding to the coordinate value, and the like are set as the design parameters. In the present embodiment, the design parameter is a coordinate of each control point. The shape of the spoke may be a plate thickness indicating a length with the corresponding control point as a reference, and the shape of the outer cylindrical body may be a plate thickness indicating a length with a point at which the spoke and the outer cylindrical body are connected as a reference.

The design parameters include design variables, and in the present embodiment, the design variables include a position of a control point moved through an input operation, a plate thickness of the spoke with the corresponding control point as a reference, and a plate thickness of the outer cylindrical body. Examples of the position of the control point as a design variable include coordinates of the control point moved through an input operation, and a movement amount of the moved control point. Examples of the plate thickness of the spoke include a plate thickness indicating a length of the spoke changed with the control point as a reference, and examples of the plate thickness of the outer cylindrical body include a plate thickness indicating a changed length of the outer cylindrical body. In the present embodiment, in order to simplify the description, a case is assumed in which a position of the control point is moved through an input operation, and the design variables include at least coordinates of the moved control point.

Although details will be described later, in the present embodiment, as an example of a preferred embodiment, the design variables will be described as including a position of the control point, a plate thickness of the spoke, and a plate thickness of the outer cylindrical body. The technology of the disclosure is not limited to applying the position of the control point, the plate thickness of the spoke, and the plate thickness of the outer cylindrical body as design variables. For example, at least one of the plate thickness of the spoke or the plate thickness of the outer cylindrical body may be set to a predetermined value in advance, and the position of the control point may be set as a design variable, or at least one of the position of the control point, the plate thickness of the spoke, or the plate thickness of the outer cylindrical body may be set as a design variable.

Hereinafter, in order to simplify the description, a case in which a position and the like of the control point are moved through an input operation will be described as an example, but the technology of the disclosure is not limited thereto. A position of the control point may be any physical position that can be moved at the time of optimization. For example, optimization may be performed as will be described later without moving the position or the like of the control point from the initial state.

The objective function or the constraint condition described above is a function of a design variable included in a design parameter. Therefore, in the tire designing device according to the present embodiment, the design parameters (the coordinates of the spoke in the tire cross-sectional shape, the plate thickness of the spoke, the plate thickness of the outer cylindrical body, and the like) that can set the rolling resistance (tire performance) to the minimum value that is the optimum value are determined while satisfying the constraint condition.

In the present embodiment, the objective function and the constraint condition are established on the premise of the mathematical programming or the like, but since the mathematical programming or the like is a general computation method, detailed description thereof will be omitted.

In the present embodiment, a design parameter that can set the rolling resistance to the minimum value while satisfying the constraint condition is determined, but the disclosure is not limited thereto. For example, it is only required to determine a design parameter that can set any objective function such as a design parameter that can set an energy loss (hysteresis loss) generated in a case in which the tire is distorted to a minimum value to an optimum value while satisfying constraint conditions.

Incidentally, in order to simulate tire performance when a non-pneumatic tire is designed, in a case in which the non-pneumatic tire is modeled, it is preferable to consider design parameters related to tire performance to reduce a processing load of a device such as reducing repetition of trial and error. Therefore, in the present embodiment, the design of the non-pneumatic tire is executed by modeling the non-pneumatic tire having an initial structure in which settings of design parameters and the like of the non-pneumatic tire are determined in advance.

The initial structure of the non-pneumatic tire is a structure of the non-pneumatic tire determined to reduce a processing load required for numerical computation compared with a case in which a calculation load required for numerical computation is not considered with respect to a control point or the like used in the case of changing a shape of the non-pneumatic tire. The initial structure includes, for example, a structure in which a plurality of control points capable of deforming the spoke are disposed along the shape of the spoke. The initial structure may include a position of the control point disposed along the spoke, a plate thickness of the spoke, and a plate thickness of the outer cylindrical body.

Next, the tire designing device 1 for a non-pneumatic tire according to the present embodiment will be described in detail.

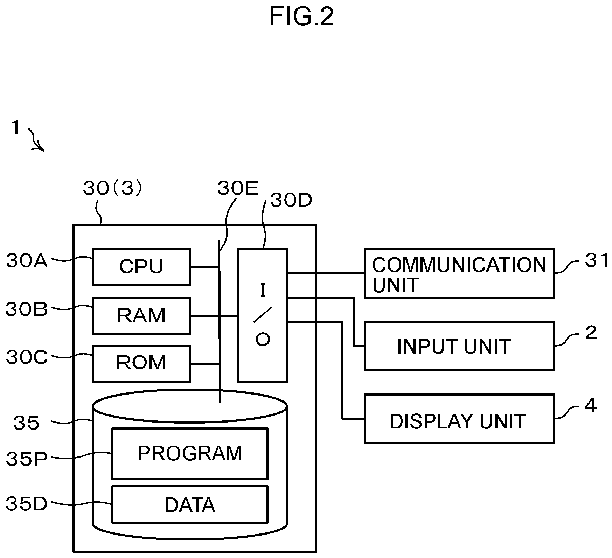

Fig. 2 is a diagram illustrating an example of an electrical configuration of the tire designing device 1. The tire designing device 1 includes a computer serving as an execution device that executes processing for realizing various functions that will be described later in the main body unit 3.

The main body unit 3 includes a computer main body 30, and the computer main body 30 includes a CPU 30A, a RAM 30B, a ROM 30C, and an I/O 30D, which are connected to each other via a bus 30E. An auxiliary storage device 35 that can be realized by a memory such as an HDD or a nonvolatile flash memory is connected to the bus 30E. A communication unit 31 for communicating with an external device is connected to the I/O 30D. An input unit 2 and a display unit 4 are connected to the I/O 30D.

The auxiliary storage device 35 may store a program 35P for causing the tire designing device 1 to execute processing. The computer main body 30 operating as the main body unit 3 reads the program 35P from the auxiliary storage device 35, loads the program into the RAM 30B, and executes processing. As a result, the computer main body 30 that has executed the program 35P operates as a device that performs processing of simulating tire performance of a non-pneumatic tire by using the tire basic model. The program 35P may be provided by a recording medium such as a CD-ROM.

The auxiliary storage device 35 stores various types of data 35D used in the computer main body 30. Although details will be described later, data indicating the initial structure can be stored in the data 35D, and the data indicating the initial structure stored in the data 35D can be used as template data indicating the initial structure of the non-pneumatic tire.

The communication unit 31 can exchange various types of information (for example, tire information including various values related to the structure and operation of the tire) with an external device (not shown) via wired connection or wireless connection.

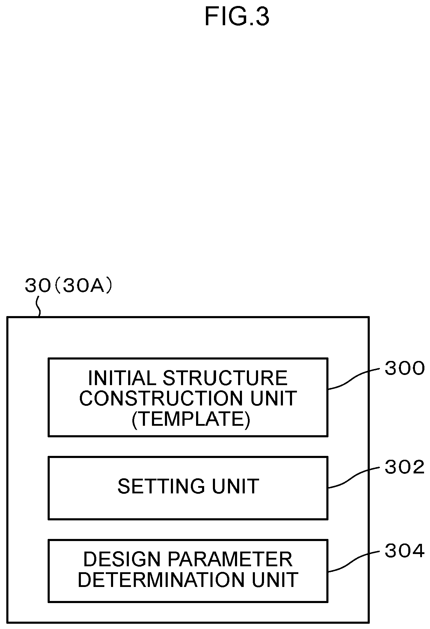

Fig. 3 is a diagram illustrating an example of a functional configuration of the computer main body 30. That is, Fig. 3 is a diagram showing an example of a configuration in which an operation unit realized by an execution body of hardware and software related to the operation (that is, processing executed by the computer main body 30) of the computer main body 30 is expressed as a block configuration.

As shown in Fig. 3, the CPU 30A of the computer main body 30 operates as the non-pneumatic tire designing device of the disclosure by executing the program 35P. The CPU 30A includes an operation unit that operates as each of an initial structure construction unit 300, a setting unit 302, and a design parameter determination unit 304.

The initial structure construction unit 300 and the setting unit 302 are examples of a setting unit of the disclosure, and the design parameter determination unit 304 is an example of a design parameter determination unit of the disclosure.

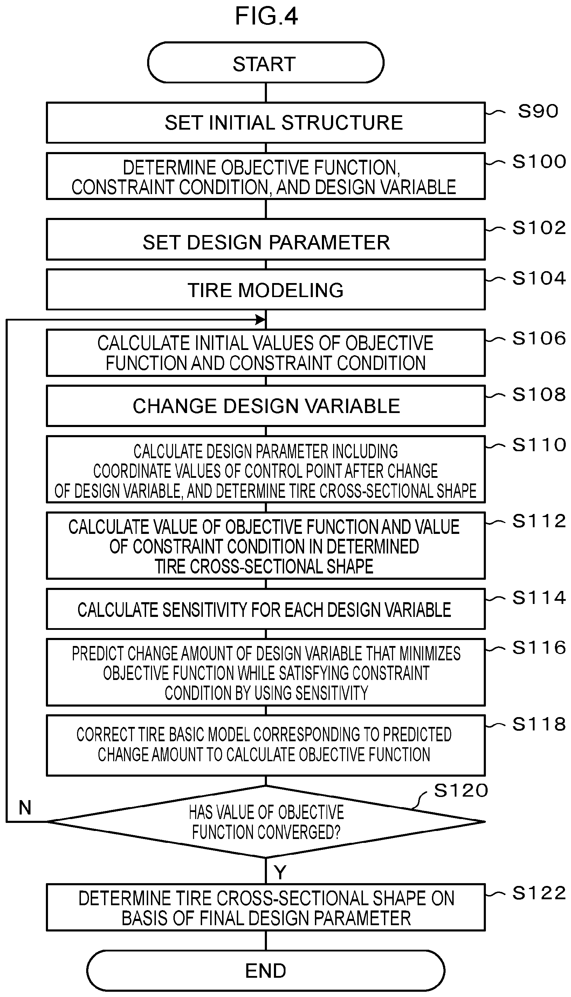

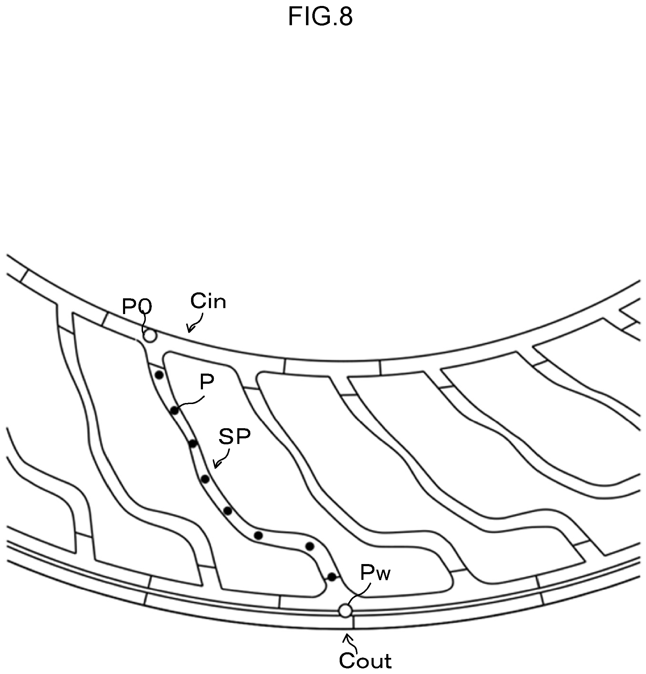

The initial structure construction unit 300 constructs a structure of the non-pneumatic tire including the control points used in the case of changing the shape of the non-pneumatic tire, and sets data indicating the constructed initial structure as the structure of the non-pneumatic tire (see step S90 shown in Fig. 4 that will be described later). The initial structure includes, for example, a control point that can deform a spoke (connection member), and a plurality of control points are disposed along the shape of the spoke (see Fig. 8). As the initial structure, data indicating a predefined structure can be used, and initial values of the position of the control point, the plate thickness of the spoke, and the plate thickness of the outer cylindrical body can be used. As the initial value of the plate thickness of the spoke, a predefined value may be used, or a value for each position of the control point may be used.

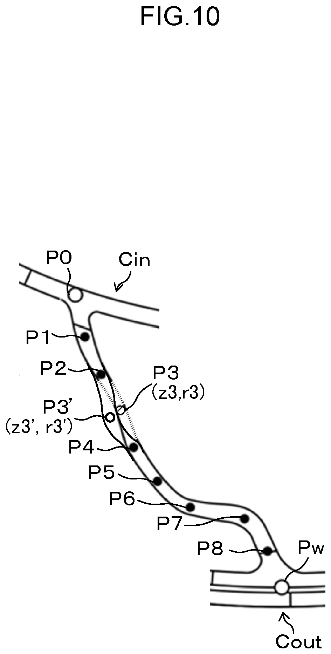

From the shape of the non-pneumatic tire having the initial structure, the shape of the non-pneumatic tire desired by a user can be set through an input operation of the user, for example, by moving a control point (see Fig. 10). The plate thickness of the spoke and the shape of the plate thickness of the outer cylindrical body (for example, thickness) may be set to desired values.

The setting unit 302 sets, for example, a tire basic model obtained by modeling a tire cross-sectional shape of a non-pneumatic tire with a finite number of elements, an objective function representing tire performance, a constraint condition for constraining an allowable range of tire performance, and a design parameter for determining the modeled tire cross-sectional shape.

For example, in a case in which the control point is moved through an input operation, the setting unit 302 may set design parameters to include, as design variables, a position (for example, (z3', r3') shown in Fig. 10) of an operation control point (for example, Pm3 shown in Fig. 10) which is the moved control point and a position of the operation control point (for example, P3 shown in Fig. 10) before the movement (see step S102 shown in Fig. 4 that will be described later).

In a case in which the control point is moved through the input operation, the setting unit 302 may move a control point other than the moved control point according to a ratio at which the control point is moved. For example, a ratio between the position (for example, (z3', r3') shown in Fig. 10) of the operation control point (for example, P3' shown in Fig. 10) that is the moved control point and the position (for example, (z3, r3) shown in Fig. 10) before the movement of the operation control point (for example, P3 shown in Fig. 10) may be calculated, operation non-control points (for example, P1, P2, and P4 to P8 shown in Fig. 10) that are other control points other than the operation control point may be moved according to the ratio, the position of the operation control point (for example, P3' shown in Fig. 10) after the movement may be set as a design variable to be included in a design parameter, and the position of the operation non-control point (for example, P1' and P2' and P4' to P8' shown in Fig. 10) after the movement according to the ratio may be included in the design parameter and set (see S102 shown in Fig. 4 that will be described later).

The design parameter determination unit 304 sequentially changes the design variables included in the design parameter, and determines a final design parameter on the basis of design variables that give the optimum value of the objective function while satisfying the constraint condition (see steps S106 to S120 shown in Fig. 4 that will be described later). That is, a design variable indicating at least one of the position of the control point, the plate thickness of the spoke, or the plate thickness of the outer cylindrical body is sequentially changed, and the final design parameter is determined on the basis of a design variable that gives the optimum value of the objective function while satisfying the constraint condition.

In the present embodiment, the design parameter determination unit 304 calculates a design variable that gives the optimum value of the objective function while satisfying the constraint condition according to mathematical programming by using an objective function sensitivity that is a ratio of the change amount of the objective function to the unit change amount of the design variable and a constraint condition sensitivity that is a ratio of the change amount of the constraint condition to the unit change amount of the design variable (for example, see Formula (1) that will be described later), and determines a final design parameter by using the calculated design variable.

Next, an operation (tire designing method) of the tire designing device 1 in the present embodiment will be described.

Fig. 4 is a diagram showing an operation of the tire designing device 1 according to the present embodiment.

As shown in Fig. 4, in step S90, the tire designing device 1 sets an initial structure as a shape of the non-pneumatic tire. In the present embodiment, a case in which a tire cross-sectional shape is set as the initial structure will be described as an example. A tire structure can be constructed by developing the tire cross-sectional shape in the tire width direction.

Here, processing of setting the initial structure of the non-pneumatic tire in step S90 will be described in detail.

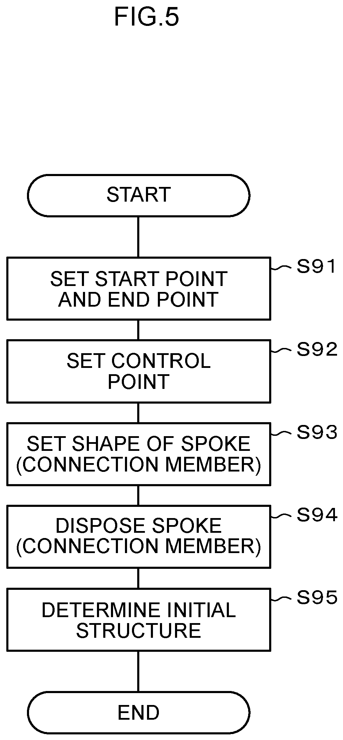

Fig. 5 is a diagram showing a flow of processing of setting the initial structure of the non-pneumatic tire.

Fig. 6 is a diagram showing a plurality of control points set as the initial structure of the non-pneumatic tire.

The initial structure of the non-pneumatic tire is set as follows.

First, in step S91, a connection point indicating a portion where an inner cylindrical body Cin of the non-pneumatic tire is connected to a spoke (connection member) SP is set as a start point P0, and a connection point indicating a portion where an outer cylindrical body Cout is connected to the spoke SP is set as an end point Pw. The positions of the start point P0 and the end point Pw are set such that an angle formed by a straight line connecting a predetermined position O (for example, the tire rotation center) and the start point P0 in the tire radial direction and a straight line connecting the predetermined position O and the end point Pw is a predetermined angle θ. In this case, the end point Pw is preferably set at an intersection of a straight line passing through the predetermined point O in the vertical direction and the outer cylindrical body Cout.

Next, in step S92, a position of each of the plurality of control points P is set by using a straight line Lst connecting the start point P0 and the end point Pw. Specifically, a predetermined quadrangular shape (in the present embodiment, a square shape SQ) with the straight line Lst connecting the set start point P0 on the inner cylindrical body Cin side and the set end point Pw on the outer cylindrical body Cout side as one side is defined. On the square shape SQ, a straight line Led on one side facing the straight line Lst connecting the start point P0 and the end point Pw is defined as a reference line. Each of the plurality of control points P is set according to a distance from the straight line Led determined as the reference line.

In the present embodiment, the straight line Lst connecting the start point P0 and the end point Pw is equally divided into a plurality of lines (in the example in Fig. 6, equally divided into nine lines), and the control points P are set to be distributed at a predetermined distance from the straight line Led on the extension line of the straight line at the boundary portion of the divided square shape. That is, the control points P are set to be distributed at an interval of a distance Lx obtained by dividing the straight line Lst into nine in the direction of the straight line Lst (or the direction of the straight line Led) and at a predetermined distance in a direction orthogonal to the straight line Lst.

The start point P0 is set to coordinates (Z0, r0), and the end point Pw is set to coordinates (Zw, rw). The control point is set to P1(Z1, r1), ··· as coordinates of a position at a predetermined distance from the straight line Led.

For the plurality of control points, a predetermined shape (in the present embodiment, the square shape SQ), the number of divisions (or the interval Lx), and a distance LL from the straight line Led may be set as parameters with the start point P0 and the end point Pw as references.

In a case in which the setting of the plurality of control points P is ended, a structure of the spoke SP including the plurality of control points P and structures of the inner cylindrical body Cin and the outer cylindrical body Cout are set.

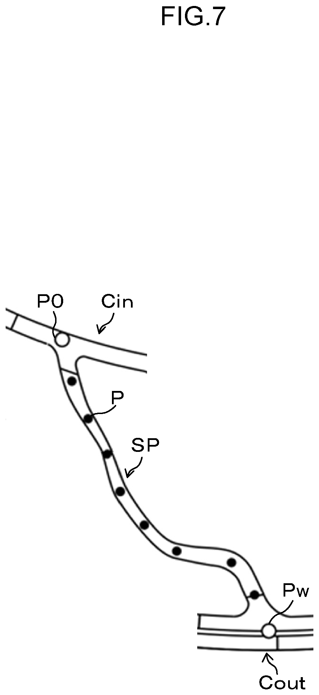

Fig. 7 is a diagram showing the spoke SP including a plurality of control points set as an initial structure of the non-pneumatic tire.

As shown in Fig. 7, the tire designing device 1 sets at least the shape of the spoke SP on the basis of the plurality of set control points such that the inner cylindrical body Cin and the outer cylindrical body Cout are connected to the spoke (connection member) SP. Specifically, in step S93 in Fig. 5, the shape of the spoke SP and the like, that is, the shape of the spoke SP, and the shapes of the inner cylindrical body Cin and the outer cylindrical body Cout connected to the spoke SP are set. Hereinafter, the spoke SP and the inner cylindrical body Cin and the outer cylindrical body Cout connected to the spoke SP may be simply referred to as the spoke SP. In the present embodiment, as the shapes of the inner cylindrical body Cin and the outer cylindrical body Cout, a case will be described in which a predefined shape in which the thickness of the cross section is a predefined plate thickness (tin, tout) is set.

In the shape setting of the spoke SP, the positions of the plurality of control points P are connected by a predetermined curve or a curve (for example, a spline curve) derived by an interpolation method, so that the curve is set as the shape of the center line SPc of the spoke. A predefined plate thickness Ti is set in a direction perpendicular to the center line SPc of the spoke SP at each of the plurality of control points P, and a plate thickness distribution of the spoke SP is set by connecting points indicating the set plate thickness Ti with a predetermined curve or a curve derived by an interpolation method. Instead of the spline curve, a curve interpolated by using a Lagrangian interpolation method, a circular interpolation method, a B-spline curve, a Bezier curve, an NURBS (weight B-spline), or the like may be used as the curve connecting the plurality of control points P and the curve connecting the plate thickness.

Fig. 8 is a diagram showing a tire structure set as an initial structure of the non-pneumatic tire.

As shown in Fig. 8, in step S94, the tire designing device 1 disposes the spokes SP and the like. Specifically, the tire designing device 1 equally disposes, for example, a plurality of spokes SP having a set shape on the circumference. The shape of the spoke SP and the shapes of the inner cylindrical body Cin and the outer cylindrical body Cout connected to the spoke SP may be set as one unit, and for example, a plurality of the spokes SP and the inner cylindrical body Cin and the outer cylindrical body Cout may be equally disposed in the tire rotational direction. The disposition of the plurality of spokes SP is not limited to the uniform disposition. For example, the spokes may be disposed at predefined intervals. The plate thicknesses of the inner cylindrical body Cin and the outer cylindrical body Cout may be set as predetermined values in step S94.

Next, in step S95, the structure of the spoke SP including the plurality of control points P set as described above and the structures of the inner cylindrical body Cin and the outer cylindrical body Cout are determined as the initial structure of the non-pneumatic tire.

In the present embodiment, the square shape SQ is adopted as an example of a predetermined quadrangular shape in the setting of the plurality of control points P. However, the shape is not limited to a square shape, and may be a rectangular shape, a parallelogram, or another quadrangular shape. In the case of adopting a quadrangular shape such as a rectangular shape, the distance formed by the straight line Lst and the straight line Led is preferably determined to be larger than the maximum distance from the straight line Lst to the control point P so that the distance from the straight line Led to the control point P is on the positive sign side. This is because the distance is handled as a positive integer.

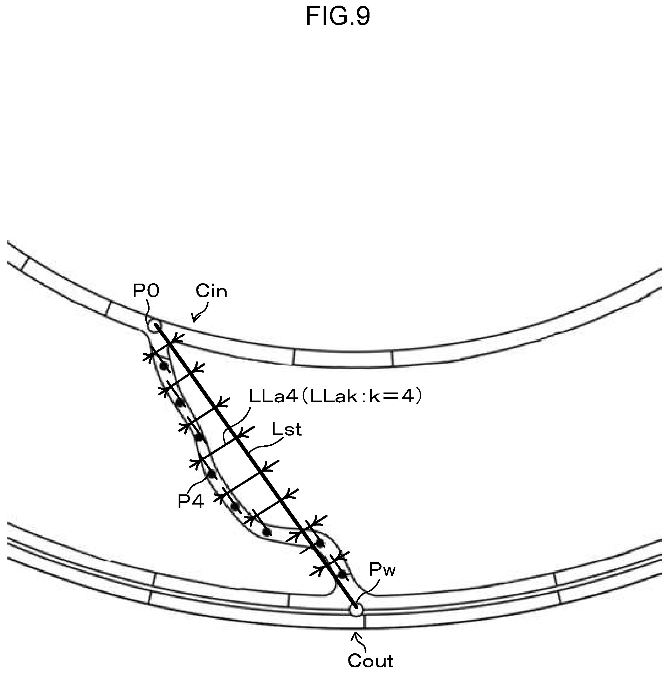

In the present embodiment, the plurality of control points are set using a figure having a shape with the straight line Lst connecting the start point P0 and the end point Pw as one side, but the setting of the plurality of control points is not limited to a figure having a shape with the straight line Lst as one side. For example, as shown in Fig. 9, the position of the control point may be set according to the distance to the control point with the straight line Lst connecting the start point P0 and the end point Pw as a reference line. Fig. 9 is a diagram showing an example of a plurality of control points set as an initial structure of a non-pneumatic tire. The position of the control point may be set according to the distance to the control point with a straight line Lst' at a position moved (offset) by a predetermined distance from the straight line Lst as a reference line.

In a case in which the setting of the initial structure of the non-pneumatic tire described above is ended, the tire designing device 1 determines the objective function, the constraint condition, and the design variable in step S100 shown in Fig. 4. In the present embodiment, as will be described later, the tire designing device 1 determines the rolling resistance of the tire as an objective function, and determines a condition indicating an allowable range of cornering power generated in the tire as a constraint condition.

### Objective function OBJ: rolling resistance

### Constraint condition G: cornering power generated in tire is -3% or more of initial shape

Fig. 10 is a diagram showing an example of a state in which a control point is moved through an input operation. A change in at least one of the plate thickness of the spoke or the plate thickness of the outer cylindrical body may be added to the movement of the control point, and at least one of the plate thickness of the spoke or the plate thickness of the outer cylindrical body may be changed instead of the movement of the control point. Here, a state in which the control point is moved will be described.

In a case in which there is a control point (for example, P3' shown in Fig. 10) moved through the input operation among the control points that will be described later, the tire designing device 1 determines the moved control point (for example, P3' shown in Fig. 10) as a design variable related to the control point. In this processing, it is assumed that only which control point is the control point of the design variable is determined, and the content of the design variable, that is, a position (coordinates) of the control point moved through the input operation is set in step S102 that will be described later.

In step 102, the tire designing device 1 sets the position (for example, (z3', r3') shown in Fig. 10) of the control point (for example, P3' shown in Fig. 10) moved through the input operation as the content of the design variable as a part of the design parameter. In addition to the setting, the positions of the other control points are set in design parameters (design parameters other than design variables) (design parameter setting processing).

Next, the design parameter setting processing in step 102 will be described in detail.

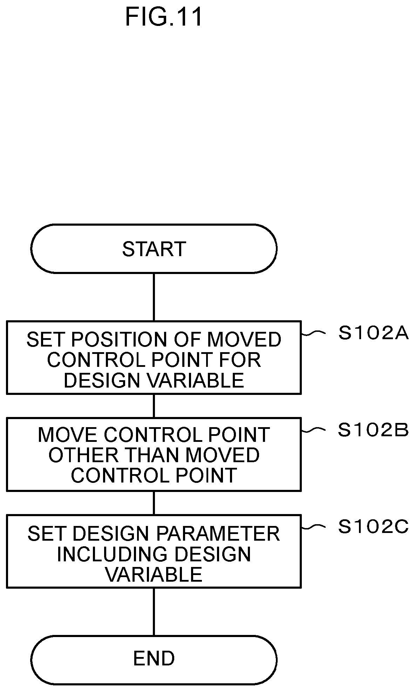

Fig. 11 is a diagram showing design parameter setting processing according to the present embodiment. In the design parameter setting processing shown in Fig. 11, an initial design parameter is determined, and a final design parameter is determined in S122 that will be described later. Here, design parameters related to control points will be described.

In the present embodiment, a case in which each control point (for example, P1, P2, and P4 to P8 shown in Fig. 10) other than a control point Pi is slid and moved according to a movement amount of the control point Pi by moving the control point Pi (for example, P3 shown in Fig. 10) before being moved through the input operation will be described as an example (see step S102B shown in Fig. 11 that will be described later).

As shown in Fig. 11, in step S102A, the tire designing device 1 sets the control point Pi' moved through the input operation as the content of the initial design variable. For example, in a case in which the control point before being moved through the input operation is P3, the tire designing device 1 sets a position (zi', ri') of the control point Pi' after being moved as the content of the design variable.

Next, in step S102B, the tire designing device 1 moves control points other than the control point Pi' moved through the input operation. In the present embodiment, in a case in which there is the control point Pi' moved through the input operation, the tire designing device 1 slides and moves other control points Pk (here, the control points P1, P2, and P4 to P8) according to a ratio between the position of the control point Pi' (here, P3' shown in Fig. 10) and the position of the control point Pi (here, P3) before the movement. For example, the other control points Pk are slid and moved such that the amount of movement decreases as the distance from the moved control point Pi' increases.

In the following description, it is assumed that the position of the control point Pk (here, the control points P1, P2, and P4 to P8) other than the control point Pi (P3 in this case) is (zk, rk){k: a number other than i}, and the position of the control point Pk' after the movement is (zk', rk').

In step S102A, the position (zi', ri') of the control point Pmi' is set as the content of the design variable, but the content of the design variable is not limited to one, and a plurality of pieces of content may exist.

Next, in step S102C, the tire designing device 1 sets initial design parameters to include the design variable set for the control point P and the coordinates of the control points other than the control point Pi'. For example, in a case in which the position of the control point Pk other than the control point Pi (P3 in this case) is (zk, rk) and the position of the control point Pk' after the movement is (zk', rk'), the position (zk', rk') and the set design variable are included in an initial design parameter.

In a case in which the design variable is changed in the present embodiment and the other embodiments, design parameters other than the design variable are also changed accordingly, similarly to the processing in steps S102B and S102C described above.

In the present embodiment, the design variables include the plate thickness of the spoke and the plate thickness of the outer cylindrical body. Therefore, the processing shown in Fig. 11 can be applied to determining the information indicating the plate thickness of the spoke and the plate thickness of the outer cylindrical body as design variables other than the design variables related to the control point. As the content of the information indicating the plate thickness of the spoke and the plate thickness of the outer cylindrical body described above, the plate thickness of the spoke and the plate thickness of the outer cylindrical body can be set as the content of the design variable for a part of the design parameter. The design parameters other than the design variables regarding the plate thickness of the spoke and the plate thickness of the outer cylindrical body include, in a case in which at least one of the plate thickness of the spoke or the plate thickness of the outer cylindrical body is changed, the other of the position of the control point changed by the change, the plate thickness of the spoke, and the plate thickness of the outer cylindrical body.

In step S102C described above, the content of the information regarding the plate thickness of the spoke and the plate thickness of the outer cylindrical body which are some of the design variables can also be set for the design parameter. In this case, design parameters related to the plate thickness of the spoke and the plate thickness of the outer cylindrical body may be fixed to predetermined values.

Returning to the processing in step S104 shown in Fig. 4, the tire designing device 1 sets a tire basic model in which at least a tire cross-sectional shape is modeled by a finite number of elements on the basis of the set design parameters. The tire cross-sectional shape may include, in addition to the cross-sectional shapes of the inner cylindrical body Cin, the outer cylindrical body Cout, and the spokes SP, structures of other constituent members configuring the non-pneumatic tire. Modeling is to quantify a tire cross-sectional shape, a material, a pattern, and the like in an input data format to a computer program capable of executing finite element method analysis and the like.

In the present embodiment, a tire cross-sectional shape in a natural equilibrium state (a state in which the non-pneumatic tire is not in contact with a road surface) is a basic shape, and a tire basic model in which the basic shape is modeled by a finite number of elements is set. The tire designing device 1 can calculate an objective function such as rolling resistance through finite element method analysis or the like by rolling the tire basic model on a virtual road surface.

The basic shape is not limited to the tire cross-sectional shape in the natural equilibrium state, and may be a tire cross-sectional shape in a state other than the natural equilibrium state. The tire basic model may be divided into a finite number of elements including a material configuring the non-pneumatic tire. The tire basic model is divided into a finite number of elements, and the divided elements may be configured in any shape such as a triangular, a quadrangular, or a cubic shape.

In step S106, the tire designing device 1 calculates an initial value OBJ0 of the objective function and an initial value G0 of the constraint condition through finite element method analysis or the like by using the tire basic model on the basis of the initial design parameters set through the processing in step S102. The processing from step S106 to step S120 is processing based on so-called mathematical programming.

In step S108, the tire designing device 1 executes processing of changing a design variable. Here, the tire designing device 1 changes design variables (zi', ri') related to the position of the control point P set through the processing in step S102 by Δzi' and Δri', respectively.

In step S110, the tire designing device 1 calculates a design parameter including coordinate values and the like of the control point after changing the design variables, and determines a tire cross-sectional shape. Here, the tire designing device 1 changes design parameters except for the design variables by using the processing in step S102 on the basis of the changed design variables (zi'+Δzi', ri'+Δri'). That is, the tire designing device 1 slides and moves the position of the control point corresponding to the design variables before being changed according to the movement amount of the control point of the changed design variables (zi'+Δzi', ri'+Δri'). The position of the control point after being slid is (zk'+Δzk', rk'+Δrk').

Therefore, the tire designing device 1 causes the position (zi'+Δzi' (hereinafter referred to as zi'), ri'+Δri' (hereinafter referred to as ri')) to be included in the design parameter as design variables to reset the design parameter, and causes the other position (zk'+Δzk' (hereinafter referred to as zk'), rk'+Δrk' (hereinafter referred to as rk')) to be included in the design parameter to reset the design parameter.

The tire designing device 1 calculates a tire cross-sectional shape (here, the cross-sectional shape of the spoke SP) corresponding to the design parameter by using a known method on the basis of the reset design parameter. The tire designing device 1 corrects the tire basic model that has already been set on the basis of the calculated tire cross-sectional shape.

In step S112, the tire designing device 1 calculates a value OBJ1 of the objective function and a value G1 of the constraint condition by using the tire basic model corrected in step S110 on the basis of the design parameter including the changed design variables (zi'+Δzi', ri'+Δri').

In step S114, the tire designing device 1 calculates, for each design variable, objective function sensitivities dOBJ/dzi' and dOBJ/dri', which are ratios of the change amount of the objective function to the predetermined change amount of the design variables, and constraint condition sensitivities dG/dzi' and dG/dri', which are ratios of the change amount of the constraint condition to the predetermined change amount of the design variables, by using the following Formula (1).

The slopes of the objective function and the constraint condition are calculated by calculating the objective function sensitivities and the constraint condition sensitivities. The tire designing device 1 can determine whether or not the current value of the objective function is in a direction of convergence according to the slopes of the objective function and the constraint condition.
[Math. 1] $\begin{matrix}\frac{dOBJ}{{dz}_{i} ′} = \frac{{OBJ}_{1} - {OBJ}_{0}}{{Δz}_{i} ′} \\ \frac{dOBJ}{{dr}_{i} ′} = \frac{{OBJ}_{1} - {OBJ}_{0}}{{Δr}_{i} ′} \\ \frac{dG}{{dz}_{i} ′} = \frac{{G}_{1} - {G}_{0}}{{Δz}_{i} ′} \\ \frac{dG}{{dr}_{i} ′} = \frac{{G}_{1} - {G}_{0}}{{Δr}_{i} ′}\end{matrix}$ (1)

In step S116, by using the initial value OBJ0 of the objective function, the initial value G0 of the constraint condition, the initial design variables, the objective function sensitivities dOBJ/dzi', dOBJ/dri', and the constraint condition sensitivities dG/dzi', dG/dri', the tire designing device 1 predicts the change amount of a design variable that minimizes the current objective function while satisfying the constraint condition according to mathematical programming.

In step S118, the tire designing device 1 corrects the tire basic model corrected in S110 again on the basis of the predicted change amount of the design variable similarly to the processing in S110. The tire designing device 1 calculates the value OBJ of the objective function by using the corrected tire basic model on the basis of the predicted change amount of the design variable.

In step S120, the tire designing device 1 determines whether or not the value OBJ of the objective function calculated through the processing in S118 has converged. For example, in a case in which a difference between the value OBJ of the objective function calculated through the processing in S118 and the initial value OBJ0 of the objective function calculated through the processing in S106 is within a range of a preset threshold, the tire designing device 1 determines that the value OBJ of the objective function calculated through the processing in S118 has converged, and proceeds to the processing in S122.

On the other hand, in a case in which the difference between the value OBJ of the objective function calculated through the processing in step S118 and the initial value OBJ0 of the objective function calculated through the processing in S106 is not within the range of the preset threshold, the tire designing device 1 determines that the value OBJ of the objective function calculated through the processing in step S118 has not converged, and returns to the processing in step S106. In a case in which the processing in S118 returns to the processing in S106 (NO is determined), the design parameter including the design variables changed through the processing in step S116 is used as an initial value.

In step S122, the tire designing device 1 determines the tire cross-sectional shape and the like on the basis of the final design parameter including the design variables changed through the processing in step S116.

In the above description, the case in which as the tire designing device 1 changes the design variables including the coordinate values of the control point has been described, but the design variables regarding the information indicating the plate thickness of the spoke and the plate thickness of the outer cylindrical body, which are other design variables, may be changed. In this case, at least one of the design variable regarding the control point, the design variable regarding the plate thickness of the spoke, or the design variable regarding the plate thickness of the outer cylindrical body may be changed to execute the above-described processing. For example, in a case in which the design variables of the control point, the plate thickness of the spoke, and the plate thickness of the outer cylindrical body are changed, the above-described processing may be executed for each design variable, or the above-described processing may be executed by simultaneously changing each design variable.

As described above, according to the present embodiment, the tire designing device 1 executes processing of setting the initial structure of the non-pneumatic tire. In the initial structure of the non-pneumatic tire, the structure of the spoke SP that connects the inner cylindrical body Cin and the outer cylindrical body Cout is set on the basis of a straight line connecting a connection portion (start point P0) between the inner cylindrical body Cin and the spoke SP and a connection portion (end point Pw) between the outer cylindrical body Cout and the spoke SP. For example, the tire designing device 1 defines the square shape SQ having the straight line Lst connecting the start point P0 and the end point Pw as one side, and sets the positions of the plurality of control points according to the distance from the straight line Led with the facing straight line Led of one side as a reference line. Thus, it is possible to set a tire model of a non-pneumatic tire that is easily deformed without setting a complicated structure. Therefore, it is possible to reduce a processing load in the case of designing a non-pneumatic tire.

In the present embodiment, the plate thickness of the spoke and the plate thickness of the outer cylindrical body can be set. That is, the tire designing device 1 sets the structure of the spoke including the control point, and sets the plate thickness of the spoke with respect to the control point and the plate thickness of the outer cylindrical body connected to the spoke, thereby setting the initial structure of the non-pneumatic tire. Therefore, since the tire designing device 1 does not need to set the complicated structure of the non-pneumatic tire from the beginning for each structure of the inner cylindrical body Cin, the outer cylindrical body Cout, and the spoke SP, the entire processing time can be shortened.

As a result, a tire designer can form a special tire cross-sectional shape in a short time by using information regarding at least one of each control point disposed on the spoke SP, the plate thickness of the spoke, or the plate thickness of the outer cylindrical body with a small number of man-hours.

The tire designing device 1 gradually changes the initial design variable by using mathematical programming so that the value of the objective function approaches the optimum value while satisfying the constraint condition, and calculates the design variable that gives the optimum value of the objective function while satisfying the constraint condition. Therefore, the tire designer can design and develop a tire with an appropriate design variable mainly based on a computer computation method instead of a design variable based on an empirical rule, and more efficient tire design and development can be performed.

### <Second Embodiment>

Next, a second embodiment will be described. The second embodiment is a modification of the first embodiment. Since the second embodiment has the same configuration as that of the first embodiment described above, only differences from the first embodiment will be described below, and description of common parts will be omitted.

In the first embodiment, the tire designing device 1 sets the non-pneumatic tire structure by disposing the plurality of spokes including the plurality of control points set by using the straight line Lst connecting the start point P0 and the end point Pw in the tire circumferential direction. In the second embodiment, a non-pneumatic tire structure is set by disposing a plurality of spoke sets in a tire circumferential direction with a plurality of spokes as spoke sets. In the second embodiment, an example of a case in which a non-pneumatic tire structure is set by disposing a plurality of spoke sets of a first spoke and a second spoke the same as or different from the first spoke in the tire circumferential direction will be described.

Processing of setting an initial structure of a non-pneumatic tire according to the second embodiment will be described in detail.

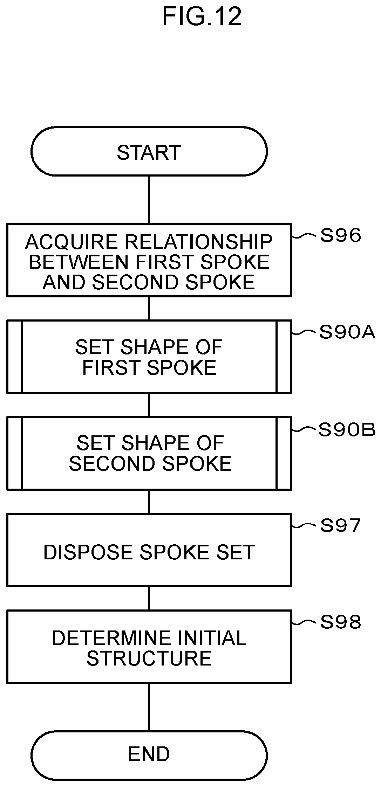

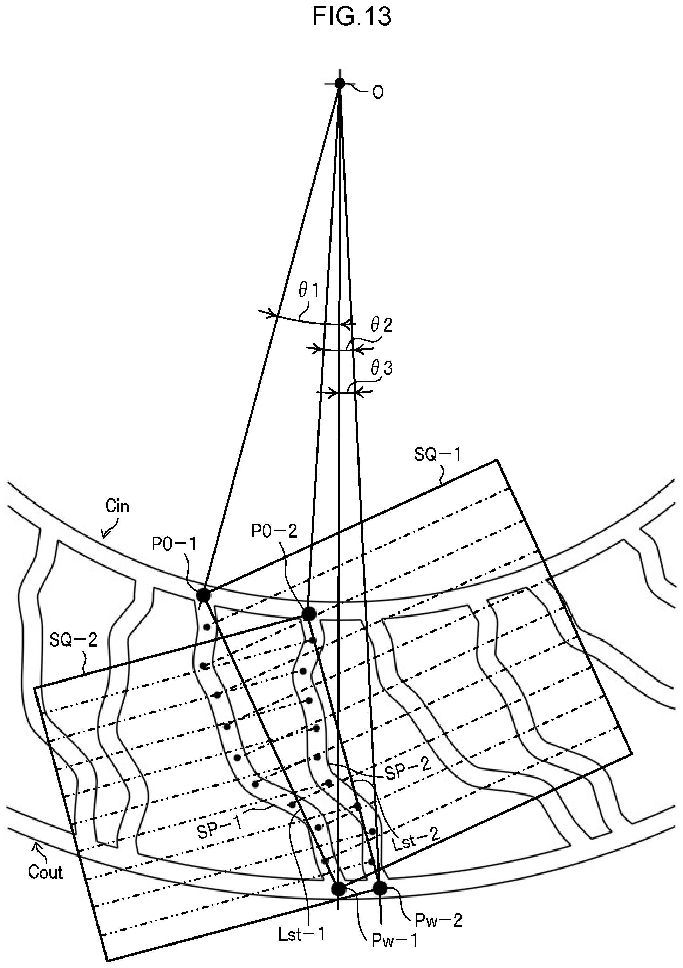

Fig. 12 is a diagram showing a flow of processing of setting an initial structure of a non-pneumatic tire according to the second embodiment. In the second embodiment, the tire designing device 1 executes setting processing shown in Fig. 12 instead of the setting processing shown in Fig. 11 described above. Fig. 13 is a diagram showing a plurality of control points set as the initial structure of the non-pneumatic tire according to the second embodiment.

As shown in Figs. 12 and 13, in step S96, the tire designing device 1 acquires information indicating a predetermined relationship between the first spoke and the second spoke. The information indicating the predetermined relationship includes information indicating a relative angle θ3 between each of angles θ1 and θ2 of the first spoke and the second spoke and a start point P0-1 and an end point Pw-1 set by the angle θ1 and a start point P0-2 and an end point Pw-2 set by the angle θ2.

In step S90A, the tire designing device 1 sets a shape of a first spoke SP-1 similarly to step S90 described above. Specifically, the tire designing device 1 sets the first start point P0-1 and the first end point Pw-1 as the first spoke SP-1 to form the angle θ1 (S91). Next, a square shape SQ-1 having a straight line Lst-1 connecting the first start point P0-1 and the first end point Pw-1 as one side is defined, and a position of each of the plurality of control points P for the first spoke SP-1 is set (S92). Next, a shape of the first spoke SP-1 or the like is set such that the spoke is connected to the inner cylindrical body Cin and the outer cylindrical body Cout on the basis of the plurality of set control points (S93). Here, similarly to the above description, shapes of the first spoke SP-1 and the like, that is, the shape of the first spoke SP-1, and the shapes of the inner cylindrical body Cin and the outer cylindrical body Cout connected to the first spoke SP-1 can be set. Hereinafter, the first spoke SP-1 and the inner cylindrical body Cin and the outer cylindrical body Cout connected to the first spoke SP-1 may be simply referred to as the first spoke SP-1.

In step S90B, the tire designing device 1 sets a shape of the second spoke SP-2 similarly to step S90A described above. In step S90B, the tire designing device 1 sets the start point P0-2 and the end point Pw-2 based on the angle θ2 such that the relative angle θ3 is obtained with respect to the first spoke SP-1 based on the angle θ1. That is, the tire designing device 1 defines a square shape SQ-2 having a straight line Lst-2 connecting the second start point P0-2 and the second end point Pw-2 as one side to form the relative angle θ3, and sets the shape of the second spoke SP-2. Here, similarly to the spoke SP-1, shapes of the spoke SP-2 and the like, that is, the shape of the spoke SP-2, and the shapes of the inner cylindrical body Cin and the outer cylindrical body Cout connected to the spoke SP-2 can be set. In a case in which the shapes of the inner cylindrical body Cin and the outer cylindrical body Cout connected to the spokes SP-1 and SP-2 are different from each other, either one may be selected, or a calculation value such as an average value may be used.

In step S97, the tire designing device 1 disposes a plurality of sets of spokes having a shape obtained by combining the first spokes SP-1 and the second spokes SP-2 having a set shape in the tire circumferential direction, for example, uniformly (at equal intervals). The disposition of the spoke sets is not limited to uniform disposition. For example, the spokes may be disposed at predefined intervals.

Next, in step S98, the tire designing device 1 determines, as the initial structures, the structure of the spoke SP including the plurality of control points P by the first spoke SP-1 and the second spoke SP-2 set as described above, and the structures of the inner cylindrical body Cin and the outer cylindrical body Cout.

In a case in which the setting of the initial structure of the non-pneumatic tire described above is ended, the tire designing device 1 determines the objective function, the constraint condition, and the design variable in step S100 shown in Fig. 4. In the present embodiment, the tire designing device 1 determines the rolling resistance of the tire as an objective function, and determines a condition indicating an allowable range of the cornering power generated in the tire as a constraint condition.

In the example shown in Fig. 13, the start point P0-1 and the end point Pw-1 of the first spoke SP-1 are determined to form the angle θ1. In this case, the end point Pw-1 is preferably set at an intersection of a straight line in the vertical direction passing through a predetermined point O and the outer cylindrical body Cout. The angle formed between the end point Pw-1 of the first spoke SP-1 and the end point Pw-2 of the second spoke SP-2 is determined by a position rotated clockwise by the angle θ3. The end point 2 of the second connection member is determined to be a position rotated clockwise by the angle θ3 from the vertical line. The determined distance between the first spoke SP-1 and the second spoke SP-2 is set to 1 pitch, and the spokes are disposed on the circumference with N pitches at equal intervals.

According to the second embodiment, the spokes connecting the inner cylindrical body Cin and the outer cylindrical body Cout can be set by the spoke set in which the first spoke SP-1 and the second spoke SP-2 are combined. Therefore, in addition to the effects of the first embodiment, it is possible to generate a structure of a non-pneumatic tire having various shapes compared with a case in which a plurality of single spokes are disposed. Therefore, it is possible to increase the degree of freedom in executing the tire design of the non-pneumatic tire. As described above, the tire designing device 1 can execute tire design that further improves tire performance by generating a structure of a non-pneumatic tire having various shapes.

### <Third Embodiment>

Next, a third embodiment will be described. The third embodiment is a modification of the second embodiment. Since the third embodiment has the same configuration as that of the first embodiment and the second embodiment described above, only differences will be described below, and description of common parts will be omitted.

In the second embodiment, the tire designing device 1 forms the second spoke SP-2 having a shape similar to that of the first spoke SP-1, and disposes a plurality of spoke sets in which the first spoke SP-1 and the second spoke SP-2 are disposed in the tire circumferential direction to set a non-pneumatic tire structure. That is, the first spoke SP-1 and the second spoke SP-2 are not crossed. In the third embodiment, the tire designing device 1 sets a second spoke SP-2 having a shape similar to that of a first spoke SP-1 and having a symmetrical shape with respect to the first spoke SP-1, and sets a non-pneumatic tire structure by disposing a plurality of spoke sets in which the first spoke SP-1 and the second spoke SP-2 are disposed to partially cross each other in the tire circumferential direction. That is, the first spoke SP-1 and the second spoke SP-2 are at least partially crossed.

Processing of setting an initial structure of a non-pneumatic tire according to the third embodiment will be described in detail.

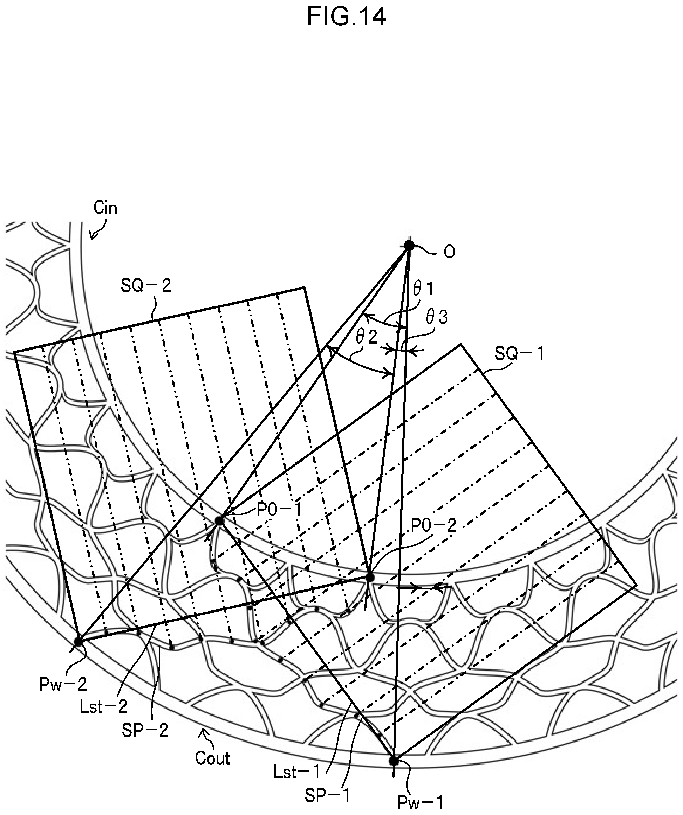

Fig. 14 is a diagram showing a plurality of control points set as an initial structure of a non-pneumatic tire according to the third embodiment.

As shown in Figs. 12 and 14, in step S96, the tire designing device 1 acquires information indicating a predetermined relationship between the first spoke and the second spoke. In the present embodiment, information including the signs of the angles θ1, θ2, and θ3 is acquired. That is, the angle θ1 and the angle θ2 have opposite signs. Therefore, the first spoke SP-1 and the second spoke SP-2 are set to have symmetrical shapes.

The tire designing device 1 sets a shape of the first spoke SP-1 in step S90A, and sets a shape of the second spoke SP-2 in step S90B. That is, the tire designing device 1 sets the first spoke SP-1 by using a square shape SQ-1 having a straight line connecting the start point P0-1 and the end point Pw-1 based on the angle θ1 as one side. The second spoke SP-2 is set by using a square shape SQ-2 having a symmetrical shape with the first spoke SP-1 and having a straight line connecting the start point P0-2 and the end point Pw-2 based on the angle θ2 as one side such that the relative angle θ3 is obtained. Here, some portions of the first spoke SP-1 and the second spoke SP-2 cross each other.

In step S97, the tire designing device 1 disposes, in the tire circumferential direction, a plurality of spoke sets each having a combination of the first spokes SP-1 and the second spokes SP-2 each having a set shape.

Next, in step S98, the tire designing device 1 determines, as the initial structures, the structure of the spoke SP including the plurality of control points P by the first spoke SP-1 and the second spoke SP-2 set as described above, and the structures of the inner cylindrical body Cin and the outer cylindrical body Cout.

According to the third embodiment, similarly to the second embodiment, it is possible to generate a structure of a non-pneumatic tire having various shapes compared with a case in which a plurality of single spokes are disposed. The first spoke SP-1 and the second spoke SP-2 are disposed as targets, and thus it is possible to increase the degree of freedom in executing the tire design of the non-pneumatic tire.

### <Fourth Embodiment>

In the first to third embodiments, the tire designing device 1 calculates a final design parameter by using mathematical programming. In contrast, in the fourth embodiment, the tire designing device 1 calculates a final design parameter by using a genetic algorithm. Since the fourth embodiment has the same configuration as that of the first embodiment described above, only differences from the first embodiment will be described below, and description of common parts will be omitted.

In the fourth embodiment, similarly to the first embodiment, the objective function is the rolling resistance. The constraint condition is also a condition that constrains the allowable range of the cornering power. The objective function and the constraint condition are not limited thereto.

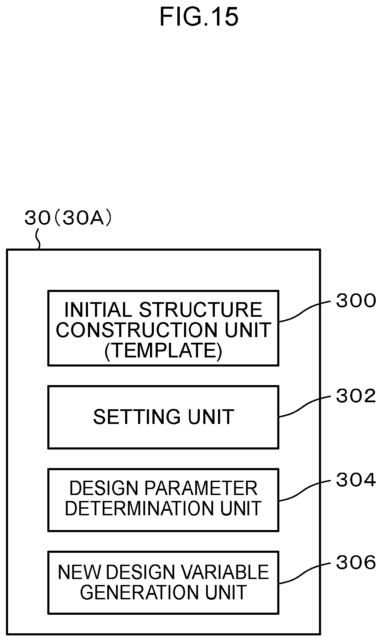

Fig. 15 is a diagram showing an example of a functional configuration of the tire designing device 1 in the fourth embodiment. As shown in Fig. 15, the tire designing device 1 includes a new design variable generation unit 306 in addition to the configuration in the first embodiment. It is assumed that the setting unit 302 sets set information including design variables configuring each of tire basic models.

The new design variable generation unit 306 sequentially selects design variables configuring each of at least two tire basic models from the set information, and executes one or both of crossover processing of generating a new design variable by exchanging a part of each of the selected design variables and mutation processing of generating a new design variable by changing a part of any one of the selected design variables at a predetermined probability.

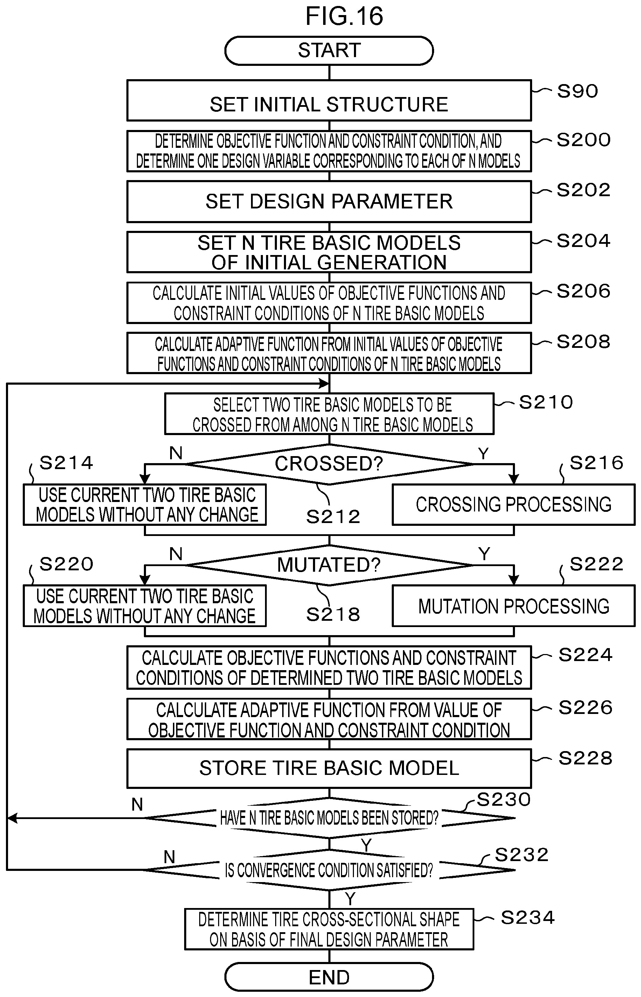

The design parameter determination unit 304 determines a final design parameter on the basis of a design variable that gives an optimum value of the objective function while satisfying the constraint condition from new set information including the generated new design variables and other selected design variables (step S234 shown in Fig. 16 that will be described later).

The design parameter determination unit 304 determines a final design parameter on the basis of a design variable that gives an optimum value of the objective function while satisfying the constraint condition among design variables included in the new set information in a case in which a predetermined convergence condition is satisfied (YES in S232 shown in Fig. 16 that will be described later), and sets the new set information as the set information and causes the new design variable generation unit 306 to repeatedly execute similar processing in a case in which the predetermined convergence condition is not satisfied (NO in step S232 shown in Fig. 16 that will be described later).

Next, an operation of the tire designing device 1 according to the present embodiment will be described.

Fig. 16 is a diagram showing an operation of the tire designing device 1 in the fourth embodiment.

As shown in Fig. 16, similarly to the first embodiment, in step S90, the tire designing device 1 sets the initial structure as the shape of the non-pneumatic tire.

Next, in step S200, the tire designing device 1 determines the rolling resistance of the tire as an objective function, and determines a condition indicating an allowable range of the cornering power generated in the tire as a constraint condition.

### Objective function OBJ: rolling resistance

Constraint condition G: cornering power is -3% or more of initial shape.

The tire designing device 1 sets set information including at least one design variable configuring each of the N tire basic models. N is input in advance by a tire designer.

Here, the set information includes N pieces of subset information (first subset information to N-th subset information). The N pieces of subset information respectively correspond to N tire basic models, and each include a design parameter including at least one design variable.

For example, in processing in step S200, the tire designing device 1 determines a design variable as P3' (see Fig. 10), and sets a design parameter including the design variable P3' in the first subset information. Similarly, the tire designing device 1 sets subset information from the second subset information to the N-th subset information. In processing in step S200, the position (z3', r3'), which is the content of the design variable, is not set yet, and is set through processing in step S202 that will be described later.

In step S202, the tire designing device 1 sets the content of the design parameter included in each of the first subset information to the N-th subset information (design parameter setting processing). For example, in a case in which the design variable included in the first subset information is P3', the tire designing device 1 causes the position (z3', r3') of P3' to be included in the content of the design parameter to set the content of the design parameter. Similarly, the tire designing device 1 sets the content of the design parameter included in each of the second subset information to the N-th subset information. The processing in step S202 corresponds to repeating the processing in step S102 in the first embodiment N times, and thus a detailed description thereof will be omitted.

In step S204, the tire designing device 1 sets the first tire basic model to the N-th tire basic model respectively corresponding to the first subset information to the N-th subset information by using the first subset information to the N-th subset information set through the processing in step S202. Each of the first tire basic model to the N-th tire basic model is configured by design parameters. The processing in step S204 is similar to the processing in step S104 in the first embodiment, and thus a detailed description thereof will be omitted.

In step S206, the tire designing device 1 calculates an initial value OBJJ of the objective function and an initial value GJ of the constraint condition corresponding to each of the first tire basic model to the N-th tire basic model according to finite element method analysis or the like using the first tire basic model to the N-th tire basic model on the basis of the design parameter for each tire basic model set through the processing in step S202 (J; 1 to N).

In step S208, the tire designing device 1 calculates a fitness function FJ corresponding to each of the first tire basic model to the N-th tire basic model by using the initial value OBJJ of the objective function and the initial value GJ of the constraint condition corresponding to each of the first tire basic model to the N-th tire basic model according to the following Formula (2). In the present embodiment, it is necessary to minimize the rolling resistance. Therefore, the value (fitness) of the fitness function increases as the rolling resistance decreases.
[Math. 2] $\begin{matrix}ΦJ = OBJJ + γ ⋅ Max \left(GJ, 0\right) \\ FJ = - ΦJ \\ or \\ FJ = 1 / ΦJ \\ or \\ FJ = - a ⋅ ΦJ + b\end{matrix}$ (2) here, $a = \frac{{Φ}_{avg} \left(c-1\right)}{{Φ}_{avg} - {Φ}_{min}}$ $b = \frac{{Φ}_{avg} \left(c-{Φ}_{min}\right)}{{Φ}_{avg} - {Φ}_{min}}$ ${Φ}_{avg} = \frac{{\sum }_{J = 1}^{N} {Φ}_{J}}{N}$ Here, c, γ, Φmin, and ΦJ are as follows.
c; constant, γ; penalty factor
Φmin: min(Φ1, Φ2, Φ3, ..., ΦN)
ΦJ; J-th penalty function of N tire basic models (J = 1, 2, 3, ... N)
In addition, c and γ are input in advance by tire designer.

In step S210, the tire designing device 1 selects two tire basic models to be crossed from among the N tire basic models on the basis of the fitness function calculated through the processing in step S208 by using a generally known computation method of fitness proportional strategy. In a case in which the computation method of the fitness proportional strategy is used, a probability p of selecting a certain tire basic model from among the N tire basic models is calculated by the following Formula (3).

Here, the fitness proportional strategy is a computation method of selecting a tire basic model having a probability proportional to the fitness of each tire basic model. Therefore, in a case in which the rolling resistance is small (in a case in which the objective function is small), the value (fitness) of the fitness function increases, and the tire basic model having the fitness function has a high probability of being selected by Formula (3).
[Math. 3] $p = \frac{{F}_{L}}{{\sum }_{J = 1}^{N} {F}_{J}}$ (3)

Here, FL and FJ are as follows.
FL: fitness function of tire model L among N tire models
FJ: J-th fitness function J of N tire models =1, 2, 3, ···, and N

In the present embodiment, the fitness proportional strategy is used, but the disclosure is not limited thereto. For example, an expectation strategy, a rank strategy, an elite preservation strategy, a tournament selection strategy, or a GENITOR algorithm may be used (see a genetic algorithm (edited by Hiroaki Kitano)).

In step S212, the tire designing device 1 determines whether or not to cross the two tire basic models selected through the processing in step S210 with a preset probability. In a case in which the determination is positive, the tire designing device 1 proceeds to processing in step S216, and in a case in which the determination is negative, the tire designing device 1 proceeds to processing in step S214. Here, the term "crossover" indicates that some elements configuring each of the two tire basic models are exchanged with each other.

In step S214, the tire designing device 1 maintains the selected two tire basic models without performing crossover.

In step S216, the tire designing device 1 performs crossover on the selected two tire basic models (crossover processing). For example, the tire designing device 1 exchanges some of design variables of the selected first tire basic model and some of design variables of the selected N-th tire basic model (that is, another tire basic model) with each other.

Assuming that the selected two tire basic models are a tire basic model a and a tire basic model b, design variables of the tire basic model a and the tire basic model b are as follows. However, as described above with reference to Fig. 5, the position (z, r) of the control point P is set as P. The design variable is not limited to the information regarding the control point, and as described above, the information indicating at least one of the position of the control point, the plate thickness of the spoke, or the plate thickness of the outer cylindrical body can be applied as the design variable.

Design variable (vector) of tire basic model a: $Pa = \left(Pa1, Pa2,⋯, Pai, Pai+1, Pai+2,⋯, Pan-1\right)$

Design variable (vector) of tire basic model b: $Pb = \left(Pb1, Pb2,⋯, Pbi, Pbi+1, Pbi+2,⋯, Pbn-1\right)$

Here, the crossover processing is, as described above, processing of exchanging some of design variables of a plurality of selected tire basic models with each other, and is an example of processing in a processing method known as a genetic algorithm. For example, the crossover processing is processing of generating a better model than before crossover by multiplying the genetic information of the parent model by partially exchanging genes which are elements. As a result, it is possible to generate a model similar to that before crossover.

For example, a crossover position (a position of a design variable) is determined by using a random number, and the design variable of the tire basic model a and the design variable of the tire basic model b are crossed at the crossover position determined by using the random number. The crossover processing is known processing, and thus a detailed description thereof will be omitted.

For example, in a case in which Pai and Pbi are crossover positions, the entire design variable Pa' after crossover of the tire basic model a and the entire design variable Pb' after crossover of the tire basic model b are as follows.$Pa ′ = \left(Pa1, Pa2,⋯, Pai, Pbi+1, Pbi+2,⋯, Pbn-1\right)$ $Pb ′ = \left(Pb1, Pb2,⋯, Pbi, Pai+1, Pai+2,⋯, Pan-1\right)$

Multipoint crossover, uniform crossover, or the like as shown in the genetic algorithm (edited by Hiroaki Kitano) may be used.

Next, in step S218, the tire designing device 1 determines whether or not to mutate the two tire basic models with a preset probability. In a case in which the determination is positive, the tire designing device 1 proceeds to processing in step S222, and in a case in which the determination is negative, the tire designing device 1 proceeds to processing in step S220. Here, the mutation is to change some elements configuring each of the two tire basic models (design variables in the present embodiment). By executing this mutation, a probability of including the optimal design parameter can be increased in the new set information that will be described later.

In step S220, the tire designing device 1 maintains the selected two tire basic models without mutating the two tire basic models.

In step S222, the tire designing device 1 mutates the two tire basic models (mutation processing).

Here, as described above, the mutation processing is processing of changing the content of some of the design variables of the tire basic model, and is an example of processing in a processing method known as a genetic algorithm. It is possible to avoid limiting an optimization range in an optimization space for optimizing a design variable due to the mutation processing. It is possible to leave a local solution by giving genetic information (design information) that is not in the parent model.

For example, a mutation position (a position of a design variable) is determined by using a random number, and the content of the corresponding design variable of at least one of the design variable of the tire basic model a or the design variable of the tire basic model b is changed at the mutation position determined by using the random number. Since the mutation processing is known processing, a detailed description thereof will be omitted.

For example, in a case in which Pai and Pbi are mutation positions, the entire design variable Pa' after the crossover of the tire basic model a and after the mutation, and the entire design variable Pb' after the crossover of the tire basic model b and after the mutation are as follows. 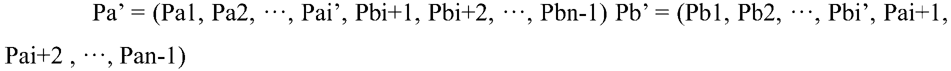 Pa' = (Pa1, Pa2, ···, Pai', Pbi+1, Pbi+2, ···, Pbn-1) Pb' = (Pb1, Pb2, ···, Pbi', Pai+1, Pai+2 , ···, Pan-1)

In step S224, the tire designing device 1 calculates the value of the objective function and the value of the constraint condition corresponding to each of the two tire basic models using the two tire basic models in step S220 or step S222.

In step S226, the tire designing device 1 uses the value of the objective function and the value of the constraint condition corresponding to each of the two tire basic models to calculate a value of the fitness function corresponding to each of the two tire basic models according to the above-described Formula (2). The value of the fitness function calculated here is used in a case in which a negative determination is made in the processing in step S230 or step S232 that will be described later and the processing in step S210 is executed again.

In step S228, the tire designing device 1 causes the two tire basic models at the time of the present processing to be included in the new set information and stores the new set information.

In step S230, the tire designing device 1 determines whether the number of tire basic models included in the new set information has reached N (predetermined convergence condition). In a case in which the determination is positive, the tire designing device 1 proceeds to the processing in step S232, and in a case in which the determination is negative, the tire designing device 1 returns to the processing in step S210 and repeats the processing until the number of tire basic models included in the new set information reaches N.

In step S232, the tire designing device 1 determines whether or not at least one of the following convergence conditions (predetermined convergence conditions) is satisfied. In a case in which the determination is positive, the tire designing device 1 proceeds to processing in step S234, and in a case in which the determination is negative, the tire designing device 1 sets N tire basic models included in the new set information as the set information, and repeats the processing in steps S210 to S228.

### - Convergence Condition

First Condition: in a case in which the number of generations (the number of repetitions) reaches M
Second Condition: in a case in which the number of small line columns that is a value of the objective function is more than or equal to q% of the whole
Third Condition: in a case in which the smallest value of the objective function is not updated in the following p generations
M, q, and p are input in advance by a tire designer. As described above, the objective function representing tire performance can be used for convergence determination.

In step S234, the tire designing device 1 selects a design variable that minimizes the objective function while satisfying the constraint condition from among the design variables of the N tire models included in the new set information, and determines a final design parameter including the design variable. The tire designing device 1 determines a tire cross-sectional shape and the like on the basis of the final design parameter.

As described above, according to the present embodiment, since the tire designing device 1 can generate various design variables by executing either or both of the crossover processing and the mutation processing with a predetermined probability, the tire designing device 1 can select a more appropriate design parameter from among design parameters each including various design variables.

Since the tire designing device 1 sequentially updates the set information and repeats similar processing until a predetermined convergence condition is satisfied, the tire designing device 1 can increase the probability that the design variable after execution of the crossover processing or the mutation processing is included in the set information each time the similar processing is repeated, and can select a more appropriate design parameter from among design parameters each including a wider variety of design variables.

The processing in the first embodiment and the processing in the fourth embodiment may be combined. Here, in a case in which the objective function and the constraint condition are calculated on the basis of the design variable calculated through the crossover processing or the mutation processing, as disclosed in the literature "Goldberg, D. E., "Genetic Algorithms in Search, Optimization and Machine Learning", Addison-Wesley (1988)", there is a problem that the value of the objective function does not fall into a local optimal solution, but it is difficult to calculate a true optimal solution. Therefore, in processing in step S224 in the fourth embodiment, the above problem is solved by executing the processing in steps S106 to S120 in the first embodiment.

As a method for solving the above problem, the simulated annealing (see genetic algorithm (edited by Hiroaki Kitano)) and the fourth embodiment may be combined.

### <Fifth Embodiment>

In the first embodiment, the tire designing device 1 calculates a final design parameter by using mathematical programming. In the fourth embodiment, the tire designing device 1 calculates a final design parameter by using a genetic algorithm. In the third embodiment, a final design parameter is calculated by using a neural network after learning, which is a nonlinear prediction technique obtained by modeling a neural network of a higher animal in an engineering manner, as a conversion system. Since the fifth embodiment has the same configuration as the first embodiment and the fourth embodiment described above, only differences from the first embodiment and the fourth embodiment will be described below, and description of common parts will be omitted.

Also in the present embodiment, similarly to the first embodiment, it is assumed that the objective function is the rolling resistance. The constraint condition is also a condition that constrains the allowable range of the cornering power. The objective function and the constraint condition are not limited thereto.

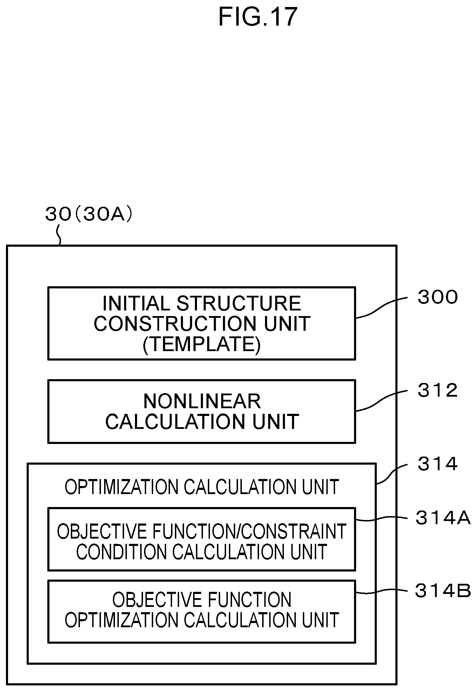

Fig. 17 is a diagram showing a functional configuration of the tire designing device 1 in the fifth embodiment. As shown in Fig. 17, the tire designing device 1 includes an operation unit that operates as each of an initial structure construction unit 300, a nonlinear calculation unit 312, and an optimization calculation unit 314.

In the present embodiment, the tire designing device 1 acquires a plurality of design parameters including the above-described design variables, tire manufacturing conditions, and the like, and a plurality of pieces of experimental data of tire performance corresponding thereto. The tire designing device 1 acquires a plurality of design parameters and a plurality of pieces of experimental data of tire performance corresponding thereto.

The nonlinear calculation unit 312 configures a setting unit that sets a conversion system that associates a design parameter with tire performance corresponding to the design parameter by using a plurality of pieces of learning data including the design parameter acquired by the input unit 2 and the experimental data of the tire performance corresponding to the design parameter.

Here, the conversion system is a conversion system capable of conversion and inverse conversion such that design parameters and the like and tire performance corresponding thereto correspond one-to-one. In a case in which the neural network after learning is expressed by a mathematical expression, this conversion system includes the mathematical expression and its coefficients.

The input unit 2 acquires optimization item information including an objective function indicating tire performance to be maximized or minimized, a constraint condition that gives a constraint in the case of maximizing or minimizing the objective function, a design parameter including the design variable, a tire manufacturing condition, a possible range of the design parameter/manufacturing condition, selection of an objective function optimization method, parameters necessary for the selected method, and the like. The optimization item information is used by the optimization calculation unit 314 that will be described later.

Although there are an optimization method according to mathematical programming and a genetic algorithm, in the present embodiment, an optimization method obtained by combining the mathematical programming and the neural network used in the first embodiment is used.

The optimization calculation unit 314 (design parameter determination unit) includes an objective function/constraint condition calculation unit 314A and an objective function optimization calculation unit 314B. The objective function/constraint condition calculation unit 314A converts a design parameter (or a manufacturing condition) (a design parameter including a new design variable) included in the optimization item information into an objective function indicating tire performance by using the conversion system calculated by the nonlinear calculation unit 312.

The objective function optimization calculation unit 314B determines whether or not the objective function predicted by the objective function/constraint condition calculation unit 314A gives an optimum value while satisfying the constraint condition, and causes the objective function/constraint condition calculation unit 314A to repeatedly calculate the objective function until a final design parameter that gives an optimum value of the objective function while satisfying the constraint condition is calculated.

Next, the nonlinear calculation unit 312 according to the present embodiment will be described. The nonlinear calculation unit 312 has a conversion function of calculating tire performance (objective function) corresponding to a design parameter (or a manufacturing condition or the like) by the conversion system configured by a neural network, and a learning function of making the conversion system more appropriate.

Here, the nonlinear calculation unit 312 may have only a conversion function without having a learning function. That is, it is sufficient that a design parameter and the tire performance corresponding thereto can be associated with each other, converted from one to the other. Therefore, a relationship between the design parameter and the tire performance corresponding thereto may be learned in advance by an external neural network, and a conversion coefficient (a coupling coefficient associating the design parameter with the tire performance corresponding thereto, or an offset value) in the trained external neural network may be applied to the neural network of the present embodiment. As a result, by adopting a configuration in which a conversion coefficient in an external neural network can be input, only the conversion function may be provided, and the learning function does not need to be provided.

A table indicating a relationship between a design parameter and tire performance corresponding thereto may be configured as a conversion system.

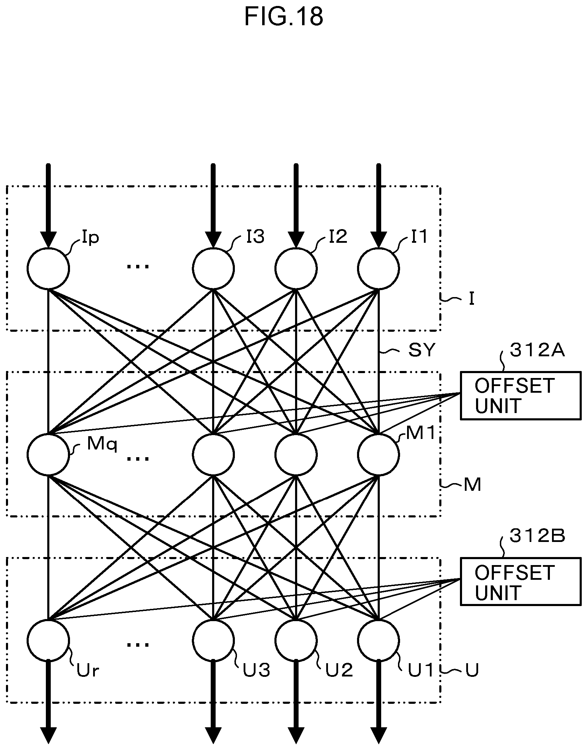

Fig. 18 is a diagram showing a configuration of a nonlinear calculation unit 312 according to the fifth embodiment. As shown in Fig. 18, the nonlinear calculation unit 312 includes a neural network including an input layer I, an intermediate layer M, an output layer U, and offset units 312A and 312B. The input layer I, the intermediate layer M, the output layer U, and the offset units 312A and 312B, which will be described later, are coupled together via a synapse SY.

The input layer I is a layer that acquires each value configuring a design parameter, and includes a predetermined number of neurons I1, I2, ..., and Ip (where p > 1). The input layer I includes a neural circuit element in which an input/output relationship of the input layer I is linear.

For example, the input layer I acquires each value configuring a design parameter including a material of a tread rubber or a spoke, coordinate values of each control point disposed along the tire cross-sectional shape, or a manufacturing cost of a tire. The number of neurons in the input layer I may be set according to the number of values configuring the design parameter. The input layer I may include a neural circuit element having a characteristic of outputting an input as it is. The information acquired in the input layer I is not limited to information regarding a control point (coordinate values of the control point), and as described above, information indicating at least one of the coordinate values of the control point indicating a position of the control point, the plate thickness of the spoke, or the plate thickness of the outer cylindrical body can be applied.

The intermediate layer M is a layer that couples the input layer I and the output layer U, and includes a predetermined number of neurons M1, M2, ..., and Mq (where q > 1).

The output layer U is a layer that outputs each value configuring the tire performance corresponding to the input design parameter, that is, the tire performance related to the objective function and the constraint condition, and includes a predetermined number of neurons U1, U2, ..., and Ur (where r > 1). The number of neurons in the output layer U may be set according to the number of values configuring the tire performance.

The intermediate layer M and the output layer U are configured by a neural circuit element having a sigmoid characteristic in which an input/output relationship of each layer is a sigmoid function. As described above, the input/output relationships of the intermediate layer M and the output layer U are configured to have the sigmoid characteristic, so that the value from the output layer U becomes an actual value (positive number).

An output value yj of each of the intermediate layer M and the output layer U can be calculated by using the following Formula (4).

That is, in each of the intermediate layer M and the output layer U, the number of synapses on the input side is defined as p, a weight (coupling coefficient) corresponding to the coupling strength of each synapse is defined as wij (1 ≤ i ≤ p, 1 ≤ j ≤ N), and each input signal is defined as xi. A virtual internal state variable ui corresponding to an average value of the neuron membrane potential and the output value yj of each of the intermediate layer M and the output layer U can be expressed by the following Formula (4).
[Math. 4] $ui = {\sum }_{i = 1}^{p} wij ⋅ xi + bj$ (4) y j =f ( u i j )

Here, bj is an offset value supplied from the offset unit 312A or 312B. wij is the coupling coefficient between the i-th and j-th elements of the different layers. As a result, in a case in which each value configuring the design parameter is input to the input layer I, each value is multiplied by the coupling coefficient, and the offset value is further added, so that each value configuring the tire performance is output.

The offset unit 312A changes the value from the input layer I. The offset unit 312B changes the value from the intermediate layer M.

In a case in which each value configuring an existing design parameter is input to the neural network at the time of learning, the nonlinear calculation unit 312 compares the value output from the neural network with training data that is each value configuring tire performance corresponding to the existing design parameter, and updates (learns) the coupling coefficients and the offset values to minimize a difference therebetween.

In a case in which each value configuring the design parameter included in the optimization item information is input after learning, the nonlinear calculation unit 312 outputs the tire performance using the trained neural network.

As described above, by performing learning and setting a more appropriate coupling coefficient for each neuron, a more appropriate value is output from each neuron, and thus more appropriate tire performance related to the design parameter included in the optimization item information is output. As a result, the final design parameter is more appropriately calculated.

Next, processing until the learning of the neural network in the nonlinear calculation unit 312 is ended will be described in detail (neural network learning processing).

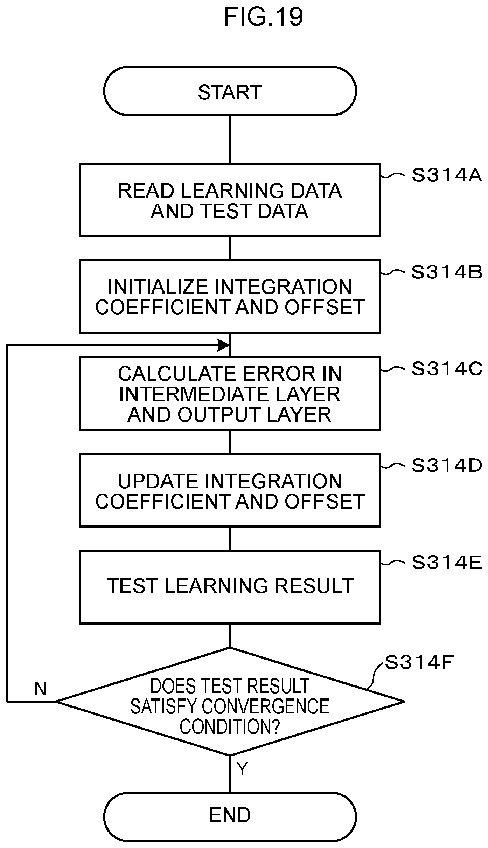

Fig. 19 is a diagram showing neural network learning processing according to the fifth embodiment. The neural network learning processing shown in Fig. 19 is executed in step S314 that will be described later.

In this neural network learning processing, existing data regarding each value configuring the design parameter and each value configuring the tire performance after the tire is prototyped and evaluated on the basis of each value, or existing data regarding each value configuring the design parameter and each value configuring the tire performance obtained by analyzing the tire basic model corresponding to each value with a computer is used. That is, a plurality of pieces of already collected existing data including each value configuring the design parameter and each value configuring the tire performance corresponding thereto is used for learning in the neural network.

In the present embodiment, a predetermined number of pieces of existing data (for example, 90% of the total) among the plurality of pieces of existing data are used as learning data. This learning data is used at the time of learning of the neural network.

Existing data (for example, the remaining 10%) other than the predetermined number of pieces of data among the plurality of pieces of existing data is used as test data. This test data is used to check whether the neural network after learning has performed optimal learning.

Hereinafter, each value configuring a design parameter included in learning data (or test data) is input to the input layer I of the neural network. Here, each value configuring tire performance included in learning data (or test data) is used as training data.

Each value configuring the design parameter included in the learning data (or the test data) is input to the input layer I, the value output from the output layer U is compared with the training data, and the coupling coefficient in the neural network is appropriately updated, whereby the neural network is trained.

Hereinafter, processing until the neural network is trained will be described in detail.

As shown in Fig. 19, in step S314A, the nonlinear calculation unit 312 reads a plurality of pieces of existing data including learning data and test data stored in advance in the RAM 30B.

In step S314B, the nonlinear calculation unit 312 sets each coupling coefficient (weight) and the offset value provided in the neural network to predetermined initial values.

In step S314C, the nonlinear calculation unit 312 inputs each value configuring the design parameter included in the learning data to the input layer I, compares the value output from the output layer U with the training data included in the learning data, and calculates an error that is a difference between the values for each piece of learning data. The nonlinear calculation unit 312 calculates an error of the intermediate layer on the basis of an error back propagation method or the like by using the error between the value output from the output layer U and the training data.

In step S314D, the nonlinear calculation unit 312 updates at least one of the coupling coefficients or the offset values for each learning data so that the error calculated through the processing in step S314C is minimized.

In step S314E, the nonlinear calculation unit 312 inputs test data to the input layer I and outputs a value output from the output layer U as a test result using a neural network including the updated coupling coefficients and offset values.

In step S314F, the nonlinear calculation unit 312 determines whether or not the test result output through the processing in step S314E satisfies the convergence condition. For example, the nonlinear calculation unit 312 determines whether or not the test result output through the processing in step S314E is within a predetermined range (convergence condition), or whether or not the number of times of the repetitive processing (convergence condition) from step S314C to step S314F has reached a predetermined number of times. The nonlinear calculation unit 312 ends the present processing in a case in which the determination is positive, and returns to the processing in step S314C in a case in which the determination is negative.

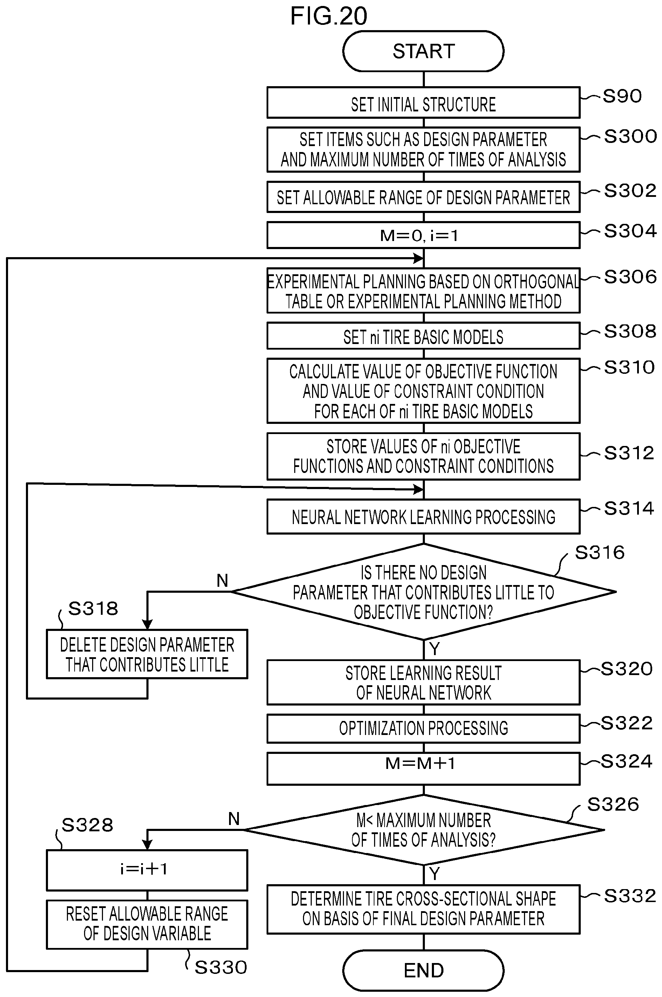

As described above, the nonlinear calculation unit 312 can update (learn) the coupling coefficients and the offset values configuring the neural network to more appropriate values by using a plurality of pieces of known learning data. In a case in which the design parameter included in the optimization item information is input, the nonlinear calculation unit 312 calculates a final design parameter that gives an optimum value to the objective function indicating the tire performance while satisfying the constraint condition by using the trained neural network (see Fig. 20 that will be described later).

The neural network learning processing may be executed before the processing shown in Fig. 20 that will be described later, or may be executed during the processing shown in Fig. 20. For example, in a case in which the neural network learning processing is executed before the processing shown in Fig. 20, in the neural network learning processing, the nonlinear calculation unit 312 stores, in the RAM 30B, the coupling coefficients and the offset values configuring the trained neural network after sufficiently training the neural network. In processing in step S314 shown in Fig. 20, the nonlinear calculation unit 312 uses a neural network (conversion system) configured by the coupling coefficients and the offset values stored in the RAM 30B.

Next, an operation of the tire designing device 1 in the present embodiment will be described in detail.

Fig. 20 is a diagram showing an operation of the tire designing device 1 in the fifth embodiment.

As shown in Fig. 20, similarly to the first embodiment, in step S90, the tire designing device 1 sets an initial structure as the shape of the non-pneumatic tire.

Next, in step S300, the tire designing device 1 determines the design parameter xi (where i = 1 to P), the objective function, the constraint condition, and the maximum number of times of analysis. That is, the tire designing device 1 determines an objective function indicating tire performance to be improved and a constraint condition thereof, and in this case, determines the number of times of analysis until a final design parameter that gives an optimum value to the objective function while satisfying the constraint condition is determined. In the present embodiment, the design parameter xi in step S300 is used as existing data in the processing in step S314 that will be described later, and is used to train the neural network. The objective function OBJ and the constraint condition G are as follows.

### Objective function OBJ: rolling resistance

Constraint Condition G: cornering power is -3% or more of the initial shape.

In step S302, the tire designing device 1 sets an allowable range (xiL ≤ xi ≤ xiU; xiL represents a lower limit value, and xiU represents an upper limit value) of the design parameter xi determined through the processing in step S300.

In step S304, the tire designing device 1 initializes M indicating the number of times of analysis and the variable i indicating the order of the design parameter (M=0 and i=1).

In step S306, the tire designing device 1 determines a design variable to be changed among the design variables included in the allowable range of the design parameter xi by using an orthogonal table (or experimental planning method) or the like. For example, the tire designing device 1 determines a design variable to be changed among the design variables included in the allowable range of the design parameter xi by using the method disclosed in the literature "Box, G. E. P., & Draper, N. R.; "Empirical Model Building and Response Surfaces",John Wiley & Sons, NewYork".

In step S308, the tire designing device 1 sets ni tire basic models configured by each of design parameters xi including the design variable determined through the processing in step S306. Processing until the tire cross-sectional shape is formed by the design variable is similar to the processing in step S102 described above, and is executed for each of the tire basic models ni.

In step S310, the tire designing device 1 calculates a value OBJJ of the objective function and a value GJ of the constraint condition corresponding to each of the design parameters of the ni tire basic models by using each of the ni tire basic models, and in step S312, stores each design parameter and the value OBJJ of the objective function and the value GJ of the constraint condition corresponding to each design parameter.

In step S314, the tire designing device 1 trains the neural network by using each value configuring the stored design parameter as learning data and using each value configuring the value OBJJ of the objective function and the value GJ of the constraint condition corresponding to the design parameter as training data. Since the processing here is similar to the processing shown in Fig. 19 described above, detailed description thereof will be omitted.

In step S316, the tire designing device 1 slightly changes the design variable included in the design parameter xi, and determines whether or not there is the design parameter xi that contributes little to the objective function. The design variable to be changed is determined through the processing in step S306.

For example, the tire designing device 1 determines that the contribution of the design parameter xi to the objective function is small in a case in which the change of the value output from the output layer is small when each value configuring the design variable included in the design parameter xi is slightly changed.

Alternatively, in a case in which the change in the value output from the output layer is small when the value output from at least one neuron configuring the input layer is set to 0, the tire designing device 1 determines that the contribution of the design parameter xi to the objective function is small.

The tire designing device 1 proceeds to processing in step S318 in a case in which there is a design parameter xi that contributes little to the objective function, and proceeds to processing in step S320 in a case in which there is no design parameter xi that contributes little to the objective function.

In step S318, the tire designing device 1 deletes design parameters that contribute little to the objective function, and uses the remaining design parameters to train the neural network again in step S314.

In step S320, the tire designing device 1 stores the coupling coefficients and the offset values configuring the trained neural network.

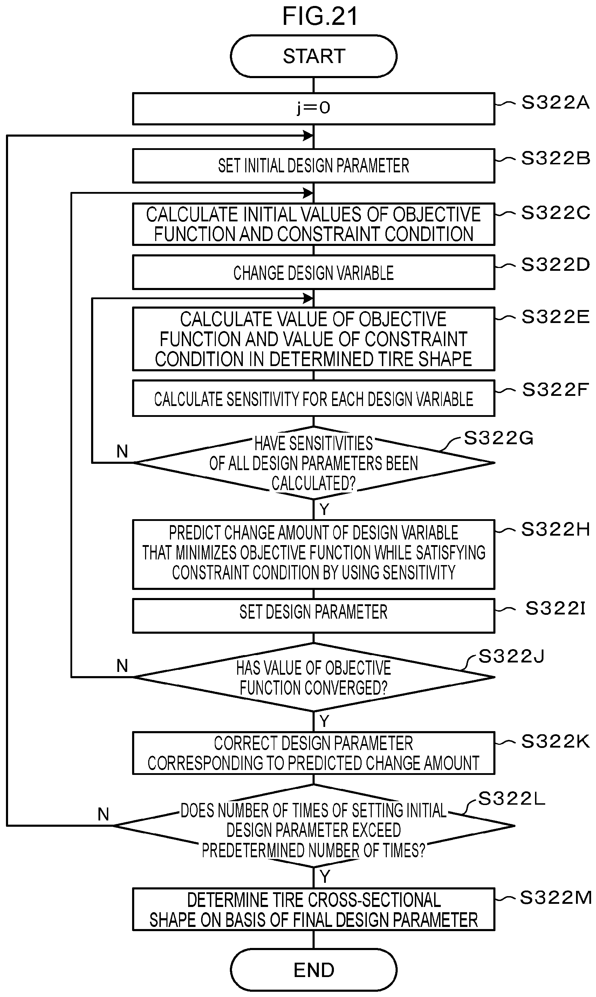

In step S322, on the basis of the design parameter included in the optimization item information (see Fig. 13), the tire designing device 1 calculates a final design parameter by using the neural network (conversion system) configured by the stored coupling coefficients and offset values. The processing here will be described in detail in optimization processing shown in Fig. 21 that will be described later.

In step S324, the tire designing device 1 calculates M=M+1.

In step S326, the tire designing device 1 determines whether or not M calculated through the processing in step S324 satisfies a relationship of M < the maximum number of times of analysis. In a case in which the determination is positive, the tire designing device 1 proceeds to processing in step S332, and in a case in which the determination is negative, the tire designing device 1 proceeds to processing in step S338.

In step S328, the tire designing device 1 calculates i=i+1.

In step S330, the tire designing device 1 resets the allowable range of the design parameter and returns to the processing in step S306. The tire designing device 1 performs resetting to narrow the allowable range of the design parameter calculated through the processing in step S302 according to the following Formula (5), and performs the design of experiments again in step S306 on the basis of the narrowed allowable range. By repeating the processing from step S306 as described above, a design parameter xi^{OPT} calculated through the processing in step S322 becomes more appropriate.
[Math. 5] $\begin{matrix}x {i}^{Lnew} ≦ x i ≦ x {i}^{Unew} \\ x {i}^{Lnew} = min \left[x {i}^{L},x {i}^{OPT}-\frac{x {i}^{U} - x {i}^{L}}{N N}\right] \\ x {i}^{Unew} = min \left[x {i}^{U},x {i}^{OPT}-\frac{x {i}^{U} - x {i}^{L}}{N N}\right]\end{matrix}$ (5)

Here, NN is a coefficient for gradually narrowing the allowable range of the design parameter, and is desirably set to a value of about 1.5 to 5.

In step S332, the tire designing device 1 determines a tire cross-sectional shape or the like on the basis of the final design parameter calculated through the processing in step S322.

The maximum number of times of analysis may be set depending on the cost for analysis, the time required to calculate the final design parameter, and the like.

Next, details of the optimization processing in step S322 described above will be described.

Fig. 21 is a diagram showing details of the optimization processing in step S322 described above.

As shown in Fig. 21, in step S322A, the tire designing device 1 initializes a variable j indicating the order of the design parameter included in the optimization item information.

In step S322B, the tire designing device 1 sets an initial value of a design parameter Sj according to the following Formula (6) on the basis of the design parameter Sj included in the optimization item information.
[Math. 6] $s {j}^{start} = s {j}^{L} + \frac{s {j}^{U} - s {j}^{L}}{Munit} ⋅ k$ (6)

Here, Sj (where j = 1 to p) is a design parameter. Sj^{L} ≤ Sj ≤ Sj^{U} is a possible range of the design parameter. Munit is the division number of the allowable range of the design parameter. k is 0 to Munit and increases by 1 every time the processing is repeated. Sj^{L} and Sj^{U} are preset.

Here, in a case in which the input value that is each design parameter is plotted on a two-dimensional plane and the value of the objective function (tire performance) for each design parameter is plotted in the height direction, the objective function has multimodal properties in a three-dimensional space.

Therefore, in a case in which only one initial value of the design parameter is used, the value of the objective function may fall into a local optimal solution. As a result, in the present embodiment, since the initial values of different design parameters are sequentially set every time the processing in step S322B is repeated, the value of the objective function is prevented from falling into a local optimal solution, and a true optimal solution can be calculated.

In step S322C, the tire designing device 1 inputs the initial value of the design parameter set through the processing in step S322B to the input layer I of the neural network, and outputs the initial value of the objective function indicating the tire performance and the initial value of the constraint condition from the output layer U.

In step S322D, the tire designing device 1 changes the design variable included in the design parameter Sj by Δsj, and in step S322E, calculates a value OBJj of the objective function and a value Gj of the constraint condition after changing the design variable by Δsj.

In step S322F, the tire designing device 1 calculates, for each design variable, an objective function sensitivity dOBJ/dsj, which is a ratio of the change amount of the objective function to the predetermined change amount of the design variable, and a constraint condition sensitivity dG/dsj, which is a ratio of the change amount of the constraint condition to the predetermined change amount of the design variable, by using the following Formula (7).
[Math. 7] $\begin{matrix}\frac{dOBJ}{dsj} = \frac{OBJj - OBJ 0}{Δsj} \\ \frac{dG}{dsj} = \frac{Gj - G 0}{Δsj}\end{matrix}$ (7)

In step S322G, the tire designing device 1 determines whether or not the processing in step S322E and step S322F has been executed for all design parameters Sj. In a case in which the determination is positive, the tire designing device 1 proceeds to the processing in step S322H, and in a case in which the determination is negative, the tire designing device 1 returns to the processing in step S322E.

In step S322H, the tire designing device 1 predicts the change amount of the design variable that minimizes the current objective function while satisfying the constraint condition according to the mathematical programming by using the initial value OBJ0 of the objective function, the initial value G0 of the constraint condition, the design parameter including the initial design variable, the objective function sensitivity dOBJ/dsj, and the constraint condition sensitivity dG/dsj.

In step S322I, the tire designing device 1 corrects the design parameter on the basis of the predicted change amount of the design variable by using the above-described processing. In a case in which the values of all the design parameters are corrected on the basis of the predicted change amount of the design variable, the tire designing device 1 calculates the value OBJ of the objective function corresponding to each of the corrected design parameters.

In step S322J, the tire designing device 1 determines, for each design parameter, whether or not the value OBJ of the objective function calculated through the processing in step S322I has converged. For example, in a case in which a difference between the value OBJ of the objective function calculated through the processing in step S322I and the initial value OBJ0 of the objective function calculated through the processing in step S322C is within the range of a preset threshold, the tire designing device 1 determines that the value OBJ of the objective function calculated through the processing in step S322I has converged, and proceeds to the processing in step S322K.

On the other hand, in a case in which the determination is negative in step S322J, the tire designing device 1 determines that the value OBJ of the objective function has not converged, and proceeds to the processing in step S322C. In a case in which the determination is negative in step S322J, the design parameter corrected through the processing in step S322I is used as the initial value.

In step S322K, the tire designing device 1 sets the design parameter corrected through the processing in step S322I.

In step S322L, the tire designing device 1 determines whether or not the number of times of setting the initial design parameter in the processing in step S322B exceeds a preset predetermined number {here, (1+Munit)}. In a case in which the determination is positive, the tire designing device 1 proceeds to processing in step S322M, and in a case in which the determination is negative, the tire designing device 1 returns to the processing in step S322B, changes the initial design parameter, and repeatedly executes the same processing.

In step S322M, the tire designing device 1 selects, as a final design parameter, a design parameter having the largest degree of coincidence with the next selection condition among the design parameters set through the processing in step S322K. This final design parameter is a design parameter that gives an optimum value of the objective function while satisfying the constraint condition.

### [Selection Conditions]

- Selection condition 1: design parameter for reducing objective function OBJ
   However, in a case in which the objective function is small, it is determined that the tire performance is high. In a case in which the objective function is large and the tire performance is high, a minus sign is assigned to the objective function.
- Selection condition 2: even in a case in which the design parameter is slightly changed around the calculated optimal solution, the objective function and the constraint condition do not change much.

As described above, according to the present embodiment, since the tire designing device 1 uses the conversion system that associates the design variable with the tire performance, the tire designing device 1 can appropriately determine the final design parameter without assuming a functional type that associates the design variable with the tire performance.

Since the tire designing device 1 can train the neural network by using the existing design variables and tire performance, the tire designing device 1 can use a conversion system with less arbitrariness, and can appropriately determine the final design parameter.

In the present embodiment, the mathematical programming (see steps S322C to S322J) and the optimization method using the neural network are used, but the disclosure is not limited thereto, and the genetic algorithm in the fourth embodiment and the optimization method using the neural network in the present embodiment may be used.

A global optimum value of the objective function may be calculated as a primary solution by using the optimization method based on the genetic algorithm in the fourth embodiment or the optimization method based on the genetic algorithm in the fourth embodiment and the neural network in the present embodiment, and an extreme value may be calculated in the vicinity of the initial value according to the optimization method based on mathematical programming with the primary solution as an initial value, and the calculated extreme value may be used as a final solution.

In this case, even in a case in which the size of the set information is finite in the genetic algorithm, the final design parameter can be made closer to the true design parameter, and the error between the value from the output layer and the value of the training data can be made smaller in the neural network, so that the optimum value of the objective function can be calculated more appropriately.

### [Examples]

Next, an Example of simulation in which the technology of the disclosure is applied to the actual design of PCR155/70R13 will be described.

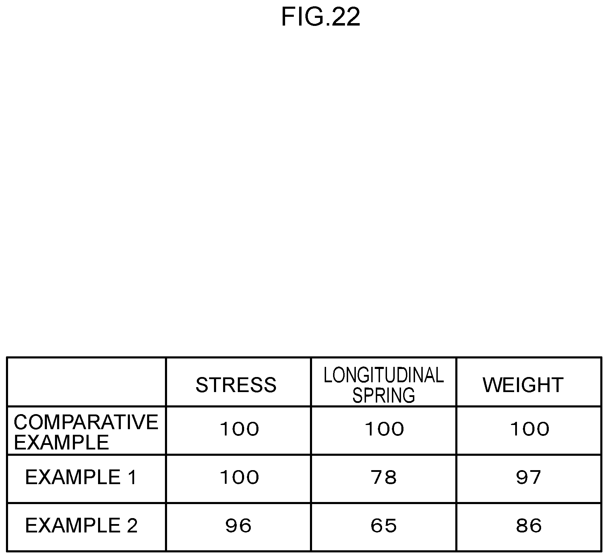

Fig. 22 shows simulation results of a non-pneumatic tire having spokes (connection members) optimized by the technology of the disclosure. Fig. 22 shows simulation results of the durability, ride comfort, and a weight of a non-pneumatic tire having spokes (connection members) optimized by the technology of the disclosure, which are indicated by indices representing stress, longitudinal spring, and weight. The smaller the stress shown in Fig. 22, the better the durability, and the smaller the longitudinal spring, the better the ride comfort.

In the Examples, a non-pneumatic tire simulation result in which the inner cylindrical body and the outer cylindrical body are connected via uniformly formed spokes is used as a comparative example. A simulation result of the non-pneumatic tire optimized by the tire designing device of the first embodiment is set as Example 1, and a simulation result of the non-pneumatic tire optimized by the tire designing device of the third embodiment is set as Example 2. The index of the simulation result indicates the simulation results of Example 1 and Example 2 with respect to the comparative example with the comparative example set to 100.

As shown in Fig. 22, in Example 1, favorable results were obtained in which the stress was equivalent, the longitudinal spring and the weight were smaller, and the tire was lighter and gave more comfortable ride. In Example 2, all of the values were smaller, and favorable results were obtained in which the tires were excellent in all of the durability, the ride comfort, and the weight. Therefore, by applying the technology of the disclosure, for example, tire performance of at least one of the durability, the ride comfort, or the weight can be set to an optimum value.

### <Other Embodiments>

Although the technology of the disclosure has been described by using the embodiments, the technical scope of the technology of the disclosure is not limited to the scope described in the above embodiments. Various modifications or improvements can be made to the above embodiments without departing from the gist of the disclosure, and the modified or improved embodiments are also included in the technical scope of the disclosed technology. For example, the specific configuration and the like of each unit described above can be appropriately changed in design. The configurations of the above-described embodiments can be combined. The operations and effects of the above-described embodiments merely enumerate the most suitable operations and effects resulting from the technology of the disclosure, and the operations and effects of the technology of the disclosure are not limited to those described in the above-described embodiments.

In the above embodiments, the processing performed by executing the program stored in the auxiliary storage device has been described, but the processing of at least a part of the program may be realized by hardware. The flow of processing of the program described in the above-described embodiment is also an example, and unnecessary steps may be deleted, new steps may be added, or the processing order may be changed within a range not departing from the gist.

In order to cause a computer to execute the processing in the above-described embodiments, a program described in a code in which the computer can process the above-described processing may be stored in a storage medium such as an optical disc and distributed.

In the above-described embodiments, the CPU has been described as an example of a general-purpose processor. However, in the above-described embodiments, the processor is a processor in a broad sense, and includes a general-purpose processor (for example, CPU: Central Processing Unit) or a dedicated processor (for example, GPU: Graphics Processing Unit, ASIC: Application Specific Integrated Circuit, FPGA: Field Programmable Gate Array, or a programmable logic device).

The operation of the processor in the above-described embodiments may be performed not only by one processor but also by a plurality of processors in cooperation, or may be performed by a plurality of processors existing at physically separated positions in cooperation.

All documents, patent applications, and technical standards described in this specification are incorporated herein by reference to the same extent as in a case in which each document, patent application, and technical standard were specifically and individually indicated to be incorporated by reference.

The disclosure of Japanese Patent Application No. 2024-011147 filed on January 29, 2024 is incorporated herein by reference in its entirety.

The disclosure includes the following aspects.

A first aspect of the disclosure is a non-pneumatic tire designing device including:
a setting unit that sets a tire basic model obtained by modeling a non-pneumatic tire including an inner cylindrical body, an outer cylindrical body, and a connection member that connects the inner cylindrical body and the outer cylindrical body with a finite number of elements, an objective function representing tire performance of the non-pneumatic tire, a constraint condition that constrains an allowable range of the tire performance, and a design parameter used to determine positions of a plurality of control points disposed along a shape of the connection member in the tire basic model of the non-pneumatic tire; and
a design parameter determination unit that sequentially changes a design variable included in the design parameter and determines the design parameter on the basis of a value of the design variable that gives an optimum value of the objective function while satisfying the constraint condition.

According to a second aspect, in the non-pneumatic tire designing device of the first aspect,
the plurality of control points are capable of changing the shape of the connection member in the tire basic model, and
the setting unit sets the design parameter to include a position of a control point as the design variable.

According to a third aspect, in the non-pneumatic tire designing device of the second aspect,
the setting unit further sets the design parameter to include, as design variables, a shape of the connection member at the position of the control point and a shape of the outer cylindrical body at a position of an end point indicating a connection point at which the outer cylindrical body and the connection member are connected to each other.

According to a fourth aspect, in the non-pneumatic tire designing device of the second aspect or the third aspect,
the tire basic model is a model indicating a tire cross-sectional shape, and
the setting unit
sets a connection point at which the inner cylindrical body and the connection member are connected to each other as a start point, sets a connection point at which the outer cylindrical body and the connection member are connected to each other as an end point, and sets a position of the start point and a position of the end point such that an angle formed by a straight line connecting a predetermined position in a tire radial direction and the start point and a straight line connecting the predetermined position and the end point is a predefined angle,
sets a position at a predefined distance from each of a plurality of positions on a straight line connecting the start point and the end point as each of the positions of the plurality of control points,
sets a shape of the connection member such that the inner cylindrical body and the outer cylindrical body are connected to the connection member on the basis of the plurality of set control points, and
sets a structure of the non-pneumatic tire by disposing a plurality of connection members each having the set shape on a tire circumference.

According to a fifth aspect, in the non-pneumatic tire designing device of the fourth aspect,
the setting unit defines a quadrangular shape (square shape) having a first straight line that is a straight line connecting the start point and the end point as one side, and sets, with a straight line of one side facing the first straight line as a second straight line, a position at a predefined distance from the second straight line as each of the positions of the plurality of control points.

According to a sixth aspect, in the non-pneumatic tire designing device of the fourth aspect or the fifth aspect,
a curve passing through the plurality of control points is set as a center line of the connection member, and
a shape having a predefined thickness with the set center line of the connection member as a center is set as a shape of the connection member.

According to a seventh aspect, in the non-pneumatic tire designing device of any one of the first to sixth aspects,
the tire basic model is a model indicating a tire cross-sectional shape, and
the setting unit
sets a connection point at which the inner cylindrical body and a first connection member that is the connection member are connected to each other as a first start point, sets a connection point at which the outer cylindrical body and the first connection member are connected to each other as a first end point, and sets a position of the first start point and a position of the first end point such that an angle formed by a straight line connecting a predetermined position in a tire radial direction and the first start point and a straight line connecting the predetermined position and the first end point is a predefined angle,
sets a position at a predefined distance from each of a plurality of positions on a straight line connecting the first start point and the first end point as each of positions of a plurality of control points of the first connection member,
sets a shape of the first connection member such that the inner cylindrical body and the outer cylindrical body are connected to the first connection member on the basis of the plurality of control points of the first connection member,
sets positions of a second start point and a second end point of a second connection member that is a connection member at a position different from a position of the first connection member,
sets a position at a predefined distance from each of a plurality of positions on a straight line connecting the second start point and the second end point as each of positions of a plurality of control points of the second connection member,
sets a shape of the second connection member such that the inner cylindrical body and the outer cylindrical body are connected to the second connection member on the basis of the plurality of control points of the second connection member, and
sets a structure of the non-pneumatic tire by disposing a plurality of connection member sets including the first connection member and the second connection member having the set shapes on a tire circumference.

According to an eighth aspect, in the non-pneumatic tire designing device of any one of the first to the seventh aspects,
the design parameter determination unit calculates the design variable that gives an optimum value of the objective function while satisfying the constraint condition on the basis of mathematical programming by using an objective function sensitivity that is a ratio of a change amount of the objective function to a unit change amount of the design variable and a constraint condition sensitivity that is a ratio of a change amount of the constraint condition to a unit change amount of the design variable.

According to a ninth aspect, in the non-pneumatic tire designing device of any one of the first to seventh aspects,
the setting unit sets set information including the design variable configuring each of the tire basic models, and
the non-pneumatic tire designing device further includes a new design variable generation unit that executes, with a predetermined probability, one or both of crossover processing of sequentially selecting the design variables configuring each of at least two of the tire basic models from the set information and exchanging some of the selected design variables of the tire basic models with each other to generate a new design variable and mutation processing of changing some of the selected design variables to generate a new design variable, in which the design parameter determination unit determines a final design parameter on the basis of the design variable that gives an optimum value of the objective function while satisfying the constraint condition in the new set information including the generated new design variables and other selected design variables.

According to a tenth aspect, in the non-pneumatic tire designing device of the ninth aspect,
in a case in which a predetermined convergence condition is satisfied, the design parameter determination unit determines the final design parameter on the basis of the design variable that gives an optimum value of the objective function while satisfying the constraint condition among the design variables included in the new set information, and in a case in which the predetermined convergence condition is not satisfied, the design parameter determination unit sets the new set information as the set information and causes the new design variable generation unit to repeatedly execute similar processing.

According to an eleventh aspect, in the non-pneumatic tire designing device of any one of the first aspect to the seventh aspect,
the setting unit sets a conversion system that associates, on the basis of a plurality of design variables already collected and tire performance corresponding to each of the design variables, the design variables with the tire performance, and the design parameter determination unit sequentially changes new design variables set by the setting unit, sequentially converts the design variables into the tire performance corresponding to the design variables by using the conversion system, and determines a final design parameter on the basis of the design variable that gives an optimum value of the tire performance while satisfying the constraint condition.

According to a twelfth aspect, in the non-pneumatic tire designing device of the eleventh aspect,
the conversion system includes a learning model in which a correspondence relationship between the design variable and tire performance corresponding to the design variable is machine-learned.

According to a thirteenth aspect, in the non-pneumatic tire designing device of any one of the first aspect to the twelfth aspect,
in a case in which a control point is moved through an input operation, the setting unit calculates a ratio between a position of the moved control point and a position of the control point before the movement, moves another control point other than the moved control point according to the ratio, and sets the design parameter to include the position of the control point after the movement as the design variable.

A fourteenth aspect is a non-pneumatic tire designing method of causing a processor to:
set a tire basic model obtained by modeling a non-pneumatic tire including an inner cylindrical body, an outer cylindrical body, and a connection member that connects the inner cylindrical body and the outer cylindrical body with a finite number of elements, an objective function representing tire performance of the non-pneumatic tire, a constraint condition that constrains an allowable range of the tire performance, and a design parameter used to determine positions of a plurality of control points disposed along a shape of the connection member in the tire basic model of the non-pneumatic tire; and
sequentially change a design variable included in the design parameter and determine the design parameter on the basis of a value of the design variable that gives an optimum value of the objective function while satisfying the constraint condition.

A program for causing a processor to execute:
setting a tire basic model obtained by modeling a non-pneumatic tire including an inner cylindrical body, an outer cylindrical body, and a connection member that connects the inner cylindrical body and the outer cylindrical body with a finite number of elements, an objective function representing tire performance of the non-pneumatic tire, a constraint condition that constrains an allowable range of the tire performance, and a design parameter used to determine positions of a plurality of control points disposed along a shape of the connection member in the tire basic model of the non-pneumatic tire; and
sequentially changing a design variable included in the design parameter and determining the design parameter on the basis of a value of the design variable that gives an optimum value of the objective function while satisfying the constraint condition.

According to the disclosure, it is possible to reduce a processing load in the case of designing a tire.

## Claims

1. A non-pneumatic tire designing device comprising:
a setting unit that sets a tire basic model obtained by modeling a non-pneumatic tire including an inner cylindrical body, an outer cylindrical body, and a connection member that connects the inner cylindrical body and the outer cylindrical body with a finite number of elements, an objective function representing tire performance of the non-pneumatic tire, a constraint condition that constrains an allowable range of the tire performance, and a design parameter used to determine positions of a plurality of control points disposed along a shape of the connection member in the tire basic model of the non-pneumatic tire; and
a design parameter determination unit that sequentially changes a design variable included in the design parameter and determines the design parameter on the basis of a value of the design variable that gives an optimum value of the objective function while satisfying the constraint condition.

2. The non-pneumatic tire designing device according to claim 1, wherein
the plurality of control points are capable of changing the shape of the connection member in the tire basic model, and
the setting unit sets the design parameter to include a position of a control point as the design variable.

3. The non-pneumatic tire designing device according to claim 2, wherein
the setting unit further sets the design parameter to include, as design variables, a shape of the connection member at the position of the control point and a shape of the outer cylindrical body at a position of an end point indicating a connection point at which the outer cylindrical body and the connection member are connected to each other.

4. The non-pneumatic tire designing device according to claim 2, wherein
the tire basic model is a model indicating a tire cross-sectional shape, and
the setting unit
sets a connection point at which the inner cylindrical body and the connection member are connected to each other as a start point, sets a connection point at which the outer cylindrical body and the connection member are connected to each other as an end point, and sets a position of the start point and a position of the end point such that an angle formed by a straight line connecting a predetermined position in a tire radial direction and the start point and a straight line connecting the predetermined position and the end point is a predefined angle,
sets a position at a predefined distance from each of a plurality of positions on a straight line connecting the start point and the end point as each of the positions of the plurality of control points,
sets a shape of the connection member such that the inner cylindrical body and the outer cylindrical body are connected to the connection member on the basis of the plurality of set control points, and
sets a structure of the non-pneumatic tire by disposing a plurality of connection members each having the set shape on a tire circumference.

5. The non-pneumatic tire designing device according to claim 4, wherein
the setting unit defines a quadrangular shape having a first straight line that is a straight line connecting the start point and the end point as one side, and sets, with a straight line of one side facing the first straight line as a second straight line, a position at a predefined distance from the second straight line as each of the positions of the plurality of control points.

6. The non-pneumatic tire designing device according to claim 4, wherein
a curve passing through the plurality of control points is set as a center line of the connection member, and
a shape having a predefined thickness with the set center line of the connection member as a center is set as a shape of the connection member.

7. The non-pneumatic tire designing device according to claim 1, wherein
the tire basic model is a model indicating a tire cross-sectional shape, and
the setting unit
sets a connection point at which the inner cylindrical body and a first connection member that is the connection member are connected to each other as a first start point, sets a connection point at which the outer cylindrical body and the first connection member are connected to each other as a first end point, and sets a position of the first start point and a position of the first end point such that an angle formed by a straight line connecting a predetermined position in a tire radial direction and the first start point and a straight line connecting the predetermined position and the first end point is a predefined angle,
sets a position at a predefined distance from each of a plurality of positions on a straight line connecting the first start point and the first end point as each of positions of a plurality of control points of the first connection member,
sets a shape of the first connection member such that the inner cylindrical body and the outer cylindrical body are connected to the first connection member on the basis of the plurality of control points of the first connection member,
sets positions of a second start point and a second end point of a second connection member that is a connection member at a position different from a position of the first connection member,
sets a position at a predefined distance from each of a plurality of positions on a straight line connecting the second start point and the second end point as each of positions of a plurality of control points of the second connection member,
sets a shape of the second connection member such that the inner cylindrical body and the outer cylindrical body are connected to the second connection member on the basis of the plurality of control points of the second connection member, and
sets a structure of the non-pneumatic tire by disposing a plurality of connection member sets including the first connection member and the second connection member having the set shapes on a tire circumference.

8. The non-pneumatic tire designing device according to claim 1, wherein
the design parameter determination unit calculates the design variable that gives an optimum value of the objective function while satisfying the constraint condition on the basis of mathematical programming by using an objective function sensitivity that is a ratio of a change amount of the objective function to a unit change amount of the design variable and a constraint condition sensitivity that is a ratio of a change amount of the constraint condition to a unit change amount of the design variable.

9. The non-pneumatic tire designing device according to claim 1, wherein
the setting unit sets set information including the design variable configuring each of the tire basic models, and
the non-pneumatic tire designing device further includes a new design variable generation unit that executes, with a predetermined probability, one or both of crossover processing of sequentially selecting the design variables configuring each of at least two of the tire basic models from the set information and exchanging some of the selected design variables of the tire basic models with each other to generate a new design variable and mutation processing of changing some of the selected design variables to generate a new design variable, in which the design parameter determination unit determines a final design parameter on the basis of the design variable that gives an optimum value of the objective function while satisfying the constraint condition in the new set information including the generated new design variables and other selected design variables.

10. The non-pneumatic tire designing device according to claim 9, wherein
in a case in which a predetermined convergence condition is satisfied, the design parameter determination unit determines the final design parameter on the basis of the design variable that gives an optimum value of the objective function while satisfying the constraint condition among the design variables included in the new set information, and in a case in which the predetermined convergence condition is not satisfied, the design parameter determination unit sets the new set information as the set information and causes the new design variable generation unit to repeatedly execute similar processing.

11. The non-pneumatic tire designing device according to claim 1, wherein
the setting unit sets a conversion system that associates, on the basis of a plurality of design variables already collected and tire performance corresponding to each of the design variables, the design variables with the tire performance, and the design parameter determination unit sequentially changes new design variables set by the setting unit, sequentially converts the design variables into the tire performance corresponding to the design variables by using the conversion system, and determines a final design parameter on the basis of the design variable that gives an optimum value of the tire performance while satisfying the constraint condition.

12. The non-pneumatic tire designing device according to claim 11, wherein
the conversion system includes a learning model in which a correspondence relationship between the design variable and tire performance corresponding to the design variable is machine-learned.

13. The non-pneumatic tire designing device according to claim 1, wherein
in a case in which a control point is moved through an input operation, the setting unit calculates a ratio between a position of the moved control point and a position of the control point before the movement, moves another control point other than the moved control point according to the ratio, and sets the design parameter to include the position of the control point after the movement as the design variable.

14. A non-pneumatic tire designing method of causing a processor to:
set a tire basic model obtained by modeling a non-pneumatic tire including an inner cylindrical body, an outer cylindrical body, and a connection member that connects the inner cylindrical body and the outer cylindrical body with a finite number of elements, an objective function representing tire performance of the non-pneumatic tire, a constraint condition that constrains an allowable range of the tire performance, and a design parameter used to determine positions of a plurality of control points disposed along a shape of the connection member in the tire basic model of the non-pneumatic tire; and
sequentially change a design variable included in the design parameter and determine the design parameter on the basis of a value of the design variable that gives an optimum value of the objective function while satisfying the constraint condition.

15. A program for causing a processor to execute:
setting a tire basic model obtained by modeling a non-pneumatic tire including an inner cylindrical body, an outer cylindrical body, and a connection member that connects the inner cylindrical body and the outer cylindrical body with a finite number of elements, an objective function representing tire performance of the non-pneumatic tire, a constraint condition that constrains an allowable range of the tire performance, and a design parameter used to determine positions of a plurality of control points disposed along a shape of the connection member in the tire basic model of the non-pneumatic tire; and
sequentially changing a design variable included in the design parameter and determining the design parameter on the basis of a value of the design variable that gives an optimum value of the objective function while satisfying the constraint condition.
